# EUROPEAN PATENT SPECIFICATION

(11) **EP 2 985 613 B1**
(45) Date of publication and mention of the grant of the patent: **09.02.2022**
(21) Application number: 14772927.1
(22) Date of filing: 27.03.2014
(51) Int. Cl.: G01R 31/08, G01R 15/14, H02H 3/38, H02H 7/26

(54) **METHOD AND SYSTEM FOR DETECTING AND LOCATING SINGLE-PHASE GROUND FAULT ON LOW CURRENT GROUNDED POWER-DISTRIBUTION NETWORK**
VERFAHREN UND SYSTEM ZUR ERKENNUNG UND ORTUNG EINPHASIGER ERDSCHLÜSSE IN EINEM GEERDETEN NIEDRIGSTROMVERTEILUNGSNETZWERK
PROCÉDÉ ET SYSTÈME DE DÉTECTION ET DE LOCALISATION D'UN DÉFAUT DE MASSE MONOPHASÉ SUR UN RÉSEAU DE DISTRIBUTION D'ÉNERGIE MIS À LA MASSE À FAIBLE COURANT

(30) Priority: 29.03.2013 CN 201310106380; 09.04.2013 CN 201310120519
(43) Date of publication of application: 17.02.2016
(73) Proprietor: Beijing Inhand Networks Technology Co., Ltd., Beijing (CN)
(72) Inventor: TANG, Xianwu, Beijing 100102 (CN); ZHANG, Jianliang, Beijing 100102 (CN); LI, Jinao, Beijing 100102 (CN); ZANG, Hongwei, Beijing 100102 (CN)
(74) Representative: AWA Sweden AB
(86) International application number: PCT/CN2014/074206
(87) International publication number: WO 2014/154164

(56) References cited:
- WO-A1-2004/068151
- CN-A- 1 421 704
- CN-A- 101 377 529
- CN-A- 102 590 703
- CN-A- 102 590 703
- CN-A- 102 608 484
- CN-A- 102 928 741
- CN-A- 102 928 741
- CN-A- 102 944 814
- CN-A- 102 944 814
- CN-U- 202 119 864
- CN-Y- 201 038 753
- JP-A- 2007 159 318
- US-A1- 2005 017 751
- US-A1- 2008 077 336

## Description

### Technical Field

The present invention relates to the technical field of electronics, and more particularly to a method and system for detecting and locating a single-phase ground fault on a low current grounded power-distribution network.

### Background

The power in a power system comes from a power plant and is transmitted to a load side via a high voltage or extra-high voltage transmission network. Then, the electric energy is distributed to users of different voltage grades by a network at a lower voltage grade. Such a network playing a major role of distribution of electric energy among power networks is known as power-distribution network. In the power system, the power-distribution network is a weak point affecting the reliability of power supply to users. Common faults of the power-distribution network mainly include short circuit faults and grounding faults. The short circuit faults include three-phase short circuit and two-phase short circuit, and a common type of grounding faults is single-phase ground faults. The detection techniques for the short circuit faults have been very mature. Unfortunately, there is still no effective method for detecting the single-phase ground faults, especially the single-phase ground faults of low current grounded power-distribution network, which has been generally recognized as a worldwide problem.

The power-distribution networks in China and some other countries mostly are low current grounded power-distribution networks, and most of faults are single-phase ground faults. The low current grounded power-distribution network has the following main advantages: when a single-phase ground fault occurs, with no short circuit formed, only an extremely low current is generated in the system, and the voltages of the lines of three phases are still symmetrical without influence on normal operation of the system. As stipulated in China power regulations, when a single-phase ground fault occurs, a low current grounded power-distribution network can continue to operate for 1-2 h with the fault. Thus, the reliability of power supply can be improved, and therefore, such power-distribution networks have been extensively used.

Nevertheless, after a single-phase ground fault occurs, the point of the single-phase ground fault must be found out as quickly as possible to clear the fault. Otherwise, overvoltage caused by the ground fault may lead to power system accidents such as cable explosion, potential transformer (PT) burnout and bus burnout. Meanwhile, if the grounded line operates as the normal line over a long period of time, it may bring great hidden troubles to the safety of local residents and livestock.

The major grounding modes of the low current grounded power-distribution networks are non-grounding and grounding via an arc suppression coil. According to DL/T620-1997 "Overvoltage Protection and Insulation Coordination for AC Electrical Installations", for a 10 kV distribution network constituted by pure overhead lines or combined overhead lines and cables, it can be ungrounded if the capacitive current in the event of a ground fault is less than 10 A; but when the capacitive current is greater than 10 A, it must be provided with an arc suppression coil. If a power-distribution network is neutral point ungrounded or grounded via an arc suppression coil, no great fault current is generated on each of phases A, B and C when a single-phase ground fault occurs, which will be described in detail in the following two cases.

### 1. The power-distribution network is neutral point ungrounded.

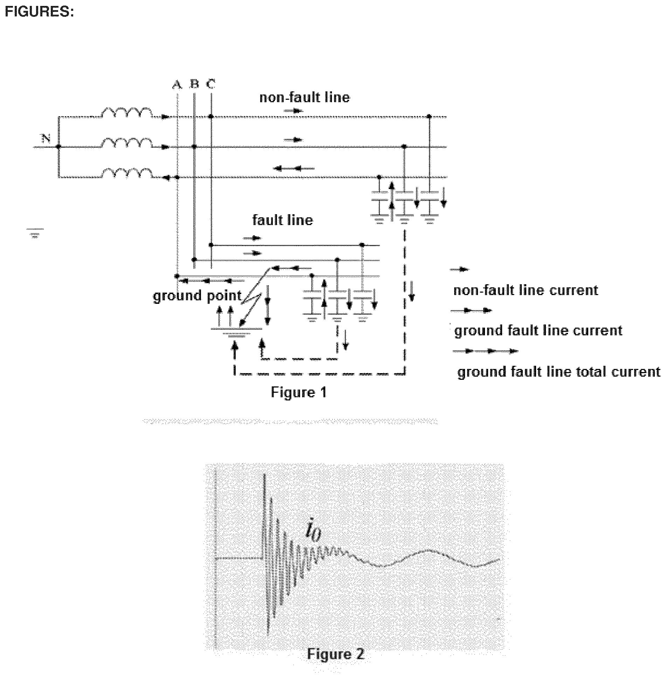

When the neutral point N of the power-distribution network is ungrounded, it is assumed that a particular point on one of phases A, B and C, for example, phase A, is grounded, as shown in Fig. 1. At the initial stage of the fault, the voltage of the fault phase A will drop rapidly, and the voltages of the non-fault phases B and C will rise rapidly. In addition, the voltage at the neutral point rises rapidly as well. Under this circumstance, a phase A feeder-to-ground distribution capacitor will rapidly discharge to ground via the grounded point, and phase B and phase C feeder-to-ground distribution capacitors will rapidly charge to ground via the grounded point, thereby forming a transient charge-discharge process (10 ms to 20 ms) and generating a great transient capacitive current. Then, the system will enter into a steady state where a power source may generate a continuous steady-state capacitive current via the distribution capacitors of the non-fault phases and the grounded point. In this process, the transient capacitive current is far greater than the steady-state capacitive current.

The currents of the lines of three phases may be directly added to obtain the zero-sequence current of the lines. Similarly, the voltages of the lines of three phases may be directly added to obtain the zero-sequence voltage of the lines. In this process, the zero-sequence current of the faulty line is as shown in Fig. 2. Before the ground fault occurs, the zero-sequence current of the lines is extremely low and approximate to 0. When the ground fault occurs, the transient capacitor charge-discharge process comes first where a great high-frequency transient capacitive current is generated, and then a steady-state capacitive current with the main energy concentrated at the power frequency (50 Hz or 60 Hz) is maintained.

### 2. The power-distribution network is neutral point grounded via an arc suppression coil.

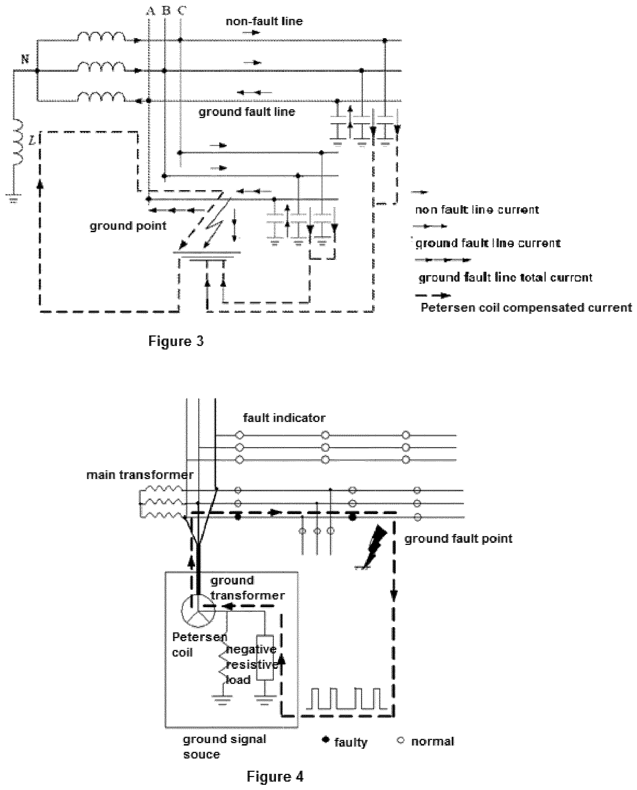

When the neutral point N of the power-distribution network is grounded via an arc suppression coil, it is assumed that a certain point on one of phases A, B and C, for example, phase A, is grounded, as shown in Fig. 3. Similar to the mode of the neutral point being ungrounded, at the initial stage of the fault, the voltage of the fault phase A will drop rapidly, and the voltages of the non-fault phases B and C will rise rapidly. In addition, the voltage at the neutral point rises rapidly as well. Under this circumstance, the phase A feeder-to-ground distribution capacitor will rapidly discharge to ground via the grounded point, and the phase B and phase C feeder-to-ground distribution capacitors will rapidly charge to ground via the grounded point, thereby forming a transient charge-discharge process (10 ms to 20 ms) and generating a great transient capacitive current. Then, the arc suppression coil L will generate a compensating current to compensate the steady-state capacitive current generated by the power source via the distribution capacitors of the non-fault phases and the grounded point, and the system then enters into the steady state. In the mode of the neutral point N being grounded via the arc suppression coil, the steady-state capacitive current in the faulty line will become extremely low without great steady-state zero-sequence current generated as shown in Fig. 2, but the transient capacitive current in the faulty line may not be affected.

In a single-phase ground fault on a low current grounded, especially grounded via an arc suppression coil, power-distribution network, the transient fault current lasts just for a very short time, and the steady-state fault current is extremely low. In addition, statistics show that the ground resistance in most of the single-phase ground faults is greater than 800 Ω; that is, high resistance grounding happens, such as grounding via branches, grassland and wet walls. Under this circumstance the transient fault current is also low and lasts for an extremely short time, which is only 10-20 ms. Therefore, the detection and location of single-phase ground faults of low current grounded power-distribution networks have been generally recognized as a worldwide problem. At present, there are several methods and methods for detecting a single-phase ground fault on a low current grounded power-distribution network as follows.

### 1. Low current line selection at a transformer substation and a device thereof

An existing low current ground fault line selection device can pick out which line among outgoing lines of a bus of the transformer substation has a ground fault. Taking Fig. 1 and Fig. 3 for example, the bus of the transformer substation has two outgoing lines, one being a faulty line and the other one being a non-faulty line, and the faulty line can be picked out by means of the existing low current ground fault line selection device.

The existing low current ground fault line selection device collects a zero-sequence voltage on the bus of the transformer substation and zero-sequence currents on various branch lines and selects the faulty line by using the steady-state information and transient information of the zero-sequence currents on various branch lines with abrupt rise of the zero-sequence voltage as a ground fault line selection. Depending on different information used, there may be a steady-state line selection device and a transient line section device.

The major line selection bases for the steady-state line selection device include:
(1) the zero-sequence current of the faulty line has the maximum amplitude;
(2) the phase of the zero-sequence current of the faulty line is opposite to that of the non-faulty line;
(3) the zero-sequence reactive power of the faulty line is negative;
(4) the zero-sequence active power of the faulty line is high;
(5) the fifth harmonic current of the faulty line is high and opposite in phase to that of the non-faulty line; and
(6) the negative-sequence current of the faulty line is high.

The major line selection bases for the transient line selection device include:
(1) the faulty line and the non-faulty line are different in both amplitudes and phases of first half waves of the transient zero-sequence current and voltage when their respective phase voltages are maximum; and
(2) the faulty line and the non-faulty line are identified by using the transient information characteristics of the zero-sequence currents extracted by other processing methods such as wavelet in combination with artificial intelligence such as a neural network.

The low current ground fault line selection device has the following main disadvantages:

### (1) The existing potential transformer (PT) and current transformer (CT) of the transformer substation are utilized with influence on the reliability and accuracy of line selection.

The zero-sequence voltage of the bus serving as a triggering signal for the low current ground fault line selection device must be obtained via the PT connected in parallel with the bus, and the ferromagnetic resonance of the PT may greatly interfere with line selection.

Since a specific zero-sequence CT is large in size and high in cost and needs to be installed under service interruption, the low current ground fault line selection device typically obtains the zero-sequence current by means of existing measuring CTs of three phases or two phases of the transformer substation instead of the specific zero-sequence CT. As an ideal CT, it has no excitation loss current; its primary coil and secondary coil are numerically identical in number of ampere-turns, and the primary current and the secondary current are identical in phase without phase offset. However, an actually utilized CT has exciting current, and therefore, its primary coil and secondary coil are not equal in number of ampere-turns, and the primary current and the secondary current are not identical as well. Therefore, actual CTs usually have angle errors and variation errors in phase, leading to an unbalance among the CTs of three phases, and the zero-sequence current superimposed by the CTs of three phases includes unbalanced current and has an error with the actual zero-sequence current with influence on the line selection result. In addition, a traditional measuring CT includes a magnetic core, and the excitation characteristic of the magnetic core is nonlinear, which affects the current linearity from low current to high current. Moreover, the magnetic core may have a magnetic saturation problem at high current, which may lead to CT saturation. In practical use, CT saturation often occurs in medium and low voltage power networks, and in this case, correct zero-sequence current cannot be obtained for line section. Furthermore, the magnetic core has an energy storage link and a hysteresis link, resulting in bad transient characteristics and bad current break following performance of the CT and difficulty in accurately capturing weak transient signals.

### (2) The ground fault cannot be accurately located.

The low current ground fault line selection device can only be installed at the branching location of the bus of the power-distribution network and can just be used for picking out the branch line having a ground fault without locating the ground fault on the branch line.

### 2. Signal injection method and device thereof

The signal injection method allows detection and location of a permanent ground fault with a high ground current by an injection signal source method in combination with fault indicators. The principle of this method is as follows: when a transformer substation detects that after the zero-sequence voltage significantly rises and lasts for a period of time and the zero-sequence current is greater than a threshold and lasts for a period of time, it can be determined that a ground fault happens and an arc suppression coil needs to be switched in. In this case, a fault current signal in a particular pattern is injected at the neutral point of a main transformer, and the fault indicators before the ground fault point all can detect the signal and give instructions, and the fault indicators behind the ground fault point all cannot the signal and may not act; thus, the location of the ground fault can be identified.

As shown in Fig. 4, a grounded signal source is connected as a controllable resistive load (medium resistance, usually more than one hundred ohms) between the neutral point of a grounded transformer of a transformer substation and ground. In case of a fault, the resistive load signal source at the neutral point of the grounded transformer of the transformer substation (it may be connected to the neutral point of the bus in the absence of the grounded transformer) is automatically switched in for a short time under the control of a microcomputer to thereby generate special low coded signal current between the transformer substation and the site grounded point. Through the coding control on the resistive load of the grounded signal source, a coded current signal superposed on the load current can be generated. The ground fault indicators installed at various locations of the outgoing lines and the line branching points of the transformer substation automatically act for indication after detecting the current signal, thereby achieving the purpose of indicating the fault.

The injection signal source method has the following advantages:
(1) It needs a signal source added to the transformer substation, such that the operating mode of the system is varied.
(2) The signal source and other devices need extra investments and construction, and service interruption is required during construction.
(3) For a common ground fault with ground resistance above 800 Ω, a high enough coded signal current cannot be generated to actuate the fault indicators to act, and high resistance ground faults cannot be detected.
(4) Instantaneous ground faults cannot be detected.

### 3. Method for detecting and locating ground fault based on interworking Feeder Terminal Units (FTUs)

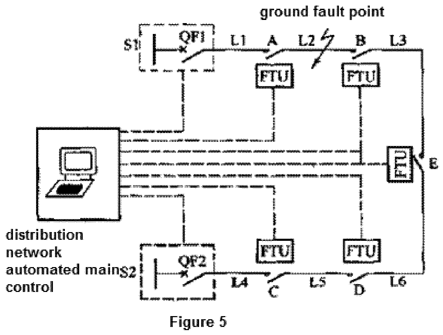

The method for detecting and locating a ground fault based on interworking FTUs is as shown in Fig. 5. The method may determine a switch section where the fault point is located by installing FTUs matching switches in the vicinity of the switches on the lines to record current and voltage waveform data of three phases in the fault and transmitting the data to a power distribution automation master station for analysis.

The method for detecting and locating a ground fault based on interworking FTUs has the following main disadvantages:
(1) It needs switches to be installed and both CT and PT must be disposed within each switch with gigantic investments on switches and FTUs.
(2) It is difficult for the measuring CTs to capture low current transient signals, and they may be saturation at high currents. When the zero-sequence current is generated through addition of three phases, a great error may be generated due to a three-phase unbalance. High resistance grounding cannot be detected easily.
(3) Each PT has the ferromagnetic resonance problem.
(4) It requires service interruption for the lines for construction when the switches and FTUs are installed.
(5) Only location in a section between switches can be achieved, and more accurate location cannot be realized.
(6) It is very difficult to provide power for the FTUs on overhead lines with influence on installation and normal operation thereof.

CN 102590703A relates to a method for selecting a single-phase ground faulty line of a resonance ground system based on zero-sequence transient charge.

CN 201038753Y relates to a steady-state zero-sequence current boosting device.

CN 102928741A relates to a system and method for locating a fault on an electric power line based on a satellite time synchronization.

CN 102944814A relates to a method for locating a single-phase ground fault on a power-distribution network based on transient signals.

CN 101377529A relates to an electrified method for measuring a zero-sequence impedance of mutual induction circuit.

At present, there is no effective method and device for detecting a ground fault in a low current grounded system, especially a system with a neutral point grounded via an arc suppression coil, with failures in quickly detecting the ground fault and indicating the location of grounding. Many power supply departments still locate ground faults by using manual troubleshooting methods such as a wire pulling method. Such methods are extremely low in automation degree, difficult to implement and low in efficiency, failing to meet the requirement of continuously improving the power supply reliability of the power system, which is becoming one of the major difficulties in improving the electric energy quality and enhancing the power supply reliability. In order to enhance the power supply reliability of the low current grounded power-distribution networks, it is necessary to provide a method and device that can effectively detect and indicate single-phase ground faults, whether low resistance grounding or high resistance grounding, transient fault or permanent fault, of the low current grounded power-distribution networks.

### Summary of the Invention

The object of the present invention is to provide a method for detecting and locating a single-phase ground fault on a low current grounded power-distribution network so as to detect and locate the location of the ground fault timely and accurately.

The object of the present invention is achieved through the technical solutions as defined in the independent claims.

### Brief Description of the Drawings

To illustrate more clearly the technical solutions of embodiments of the present invention, the accompanying drawings needed in description of the embodiments will be briefly introduced below. It is apparent that the accompanying drawings in the following description are merely some embodiments of the present invention, and for those of ordinary skill in the art, other drawings can also be obtained according to these accompanying drawings without creative work.
Fig. 1 shows single-phase ground fault currents of a neutral point N ungrounded power-distribution network.
Fig. 2 shows the zero-sequence current of a faulty line after a single-phase ground fault occurs.
Fig. 3 shows single-phase ground fault currents of a power-distribution network with neutral point N grounded via an arc suppression coil.
Fig. 4 shows a ground fault detection principle of an injection signal source method.
Fig. 5 shows a principle of a method for detecting a ground fault based on networking FTUs.
Fig. 6 shows a flow chart of a method provided by an embodiment of the present invention.
Fig. 7 shows a schematic structure diagram of a device provided by an embodiment of the present invention.
Fig. 8 shows a device provided by an embodiment of the present invention in a state where a feeder clamping mechanism is opened for installation.
Fig. 9 shows a device provided by an embodiment of the present invention in a state where a feeder clamping mechanism is locked.
Fig. 10 shows a schematic diagram of an implementation principle of a device provided by an embodiment of the present invention.
Fig. 11 shows a schematic diagram of a fault indicating unit in a device provided by an embodiment of the present invention.
Fig. 12 shows a schematic structure diagram of a system provided by an embodiment of the present invention.
Fig. 13A shows that a fault phase power-distribution network feeder monitoring unit monitors drastic variations in short-time voltage and current when a single-phase ground fault occurs;
Fig. 13B shows that the fault phase power-distribution network feeder monitoring unit triggers feeder monitoring units of other phases wirelessly and synchronously after detecting a suspected ground fault;
Fig. 13C shows that the power-distribution network feeder monitoring units of three phases transmit voltage and current waveform data through wireless communication, with the voltage and current waveform data from the feeder monitoring units of three phases being aggregated to a communication terminal and then uploaded to a system master station; and
Fig. 13D shows that platform software of the system master station distributes ground fault signals to the feeder monitoring units before the fault point on the fault phase of the power-distribution network for indication after performing ground fault detection.
Fig. 14A shows a wirelessly synchronous triggering mode of phase A simultaneously triggering phase B and phase C;
Fig. 14B shows a wirelessly synchronous triggering mode of phase A triggering phase B first and then phase B triggering phase C; and
Fig. 14C shows a wirelessly synchronous triggering mode of phase A triggering a communication terminal first and then the communication terminal triggering phase B and phase C.
Fig. 15A, Fig. 15B, Fig. 15C and Fig. 15D show four system topologies provided by embodiments of the present invention, respectively.

### Detailed Description of the Invention

The technical solutions in embodiments of the present invention will be described clearly and fully below in combination with the accompanying drawings in the embodiments of the present invention.

The embodiments of the present invention will be further described in detail below in combination with the accompanying drawings.

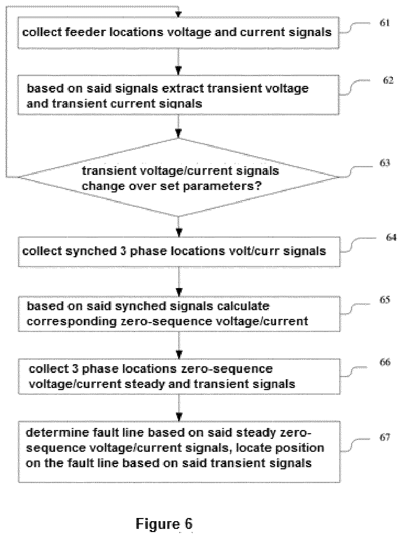

A method for detecting and locating a single-phase ground fault on a low current grounded power-distribution network provided by an embodiment of the present invention, as shown in Fig. 6, comprises the following steps.

At step 61, voltage signals and current signals at multiple locations on feeders of various phases are detected and picked up, respectively.

Specifically, voltage signals and current signals at multiple locations on feeders of various phases may be periodically picked up at a set time interval; or voltage signals and current signals at multiple locations on feeders of various phases may be picked up at specified time points; or voltage signals and current signals at multiple locations on feeders of various phases may be picked up in other set manners.

At step 62, corresponding transient voltage signals and transient current signals are extracted and determined according to the voltage signals and the current signals picked up at the step 61.

At step 63, whether extents of variation in the transient voltage signals and the transient current signals exceed preset thresholds is determined; if so, step 64 is performed; otherwise, the step 61 is performed again.

The extents of variation in the transient voltage signals and the transient current signals include:
extents of variation in the transient voltage signals and current signals calculated and determined each time in one or more of amplitude, average value, differential value and integral value. For example, two adjacent calculation results may be compared to determine the extent of variation; or
the current calculation result may be compared with the average value of multiple previous calculation results to determine the extent of variation; or the corresponding extents of variation may also be measured in other predetermined manners.

Specifically, band-pass processing may be performed on the picked-up voltage signals and current signals to obtain transient voltage signals and transient current signals, and one or more of amplitude, average value, differential value and integral value of each of the band-pass processed transient voltage signals and transient current signals are extracted. When the variation in one or more of the above values exceeds a set threshold, step 64 is performed, i.e., triggering a suspected ground fault alarm.

At step 64, when the extents of variation in the transient voltage signals and the transient current signals exceeds set thresholds, voltage signals and the current signals at multiple locations on the feeders of three phases are synchronously picked up.

The manner of synchronously picking up voltage signals and the current signals at multiple locations on the feeders of three phases may include:
synchronizing time through timing by a time division multiplexing wireless communication network in combination with timing by GPS, and synchronously picking up the voltage signals and the current signals at multiple locations on the feeders of three phases based on the synchronized time.

After the suspected ground fault alarm occurs, the feeders of the other two phases may be specifically triggered with infrared, sound, ultrasonic, magnetic field or electric magnetic field as a triggering signal. Particularly, the triggering signal may be directly transmitted to the feeders of the other two phases; or, the triggering signal is firstly transmitted to the feeder of one adjacent phase and then the feeder of the adjacent phase transmits it to the feeder of another phase among the feeders of three phases; or, the triggering signal is firstly transmitted to an adjacent wireless communication terminal device, and then transmitted by the communication terminal device to the feeders of the other two phases to notify the feeders of the other two phases of uploading voltage and current waveform data as the voltage signals and current signals of the feeders for subsequent calculation of zero-sequence voltage and zero-sequence current signals and detection of the ground fault.

At step 65, corresponding zero-sequence voltages and zero-sequence currents are calculated according to the voltage signals and the current signals that are synchronously picked up at multiple locations on the feeders of three phases.

At step 66, steady-state signals and transient signals of the zero-sequence voltages and the zero-sequence currents at various locations on the feeders of three phases are extracted.

At step 67, a faulty line is determined according to the steady-state signals of the zero-sequence voltages and the zero-sequence currents, and a specific fault location on the faulty line is determined according to the transient signals of the zero-sequence voltages and the zero-sequence currents.

In the step 67, the processing manner of determining a faulty line according to the steady-state signals of the zero-sequence voltages and the zero-sequence currents may include:
extracting the steady-state signals of the zero-sequence voltages and the zero-sequence currents at various locations, calculating characteristic values of the steady-state signals, the characteristic values including: one or more of amplitude, average value, differential value and integral value, and steady-state zero-sequence active power and steady-state zero-sequence reactive power at each location, also calculating waveform similarities between the steady-state zero-sequence voltage and zero-sequence current signals at various locations, and then screening out and determining the faulty line according to differences in the characteristic values and the waveform similarities of the steady-state signals on lines of various phases.

In the step 67, the processing manner of determining a specific fault location on the faulty line according to the transient signals of the zero-sequence voltages and the zero-sequence currents may include:
extracting the previously determined transient signals of the zero-sequence voltage and the zero-sequence current at various locations on the faulty line, calculating characteristic values of the transient signals, the characteristic values including: one or more of amplitude, average value, differential value and integral value, and transient zero-sequence active power and transient zero-sequence reactive power at each location, also calculating waveform similarities between the transient zero-sequence voltage and zero-sequence current signals at various locations, and then screening out and determining a ground fault point on the faulty line according to differences in the characteristic values and the waveform similarities of the transient signals at various locations on the faulty line.

After the ground fault point is determined by performing the above step 67, the ground fault point may also be displayed on a map of a Geographic Information System (GIS), and a ground fault signal may be distributed via a wireless communication network to a fault indicating unit at the ground fault point to display the fault so that an inspector can find the location of the fault point conveniently and quickly.

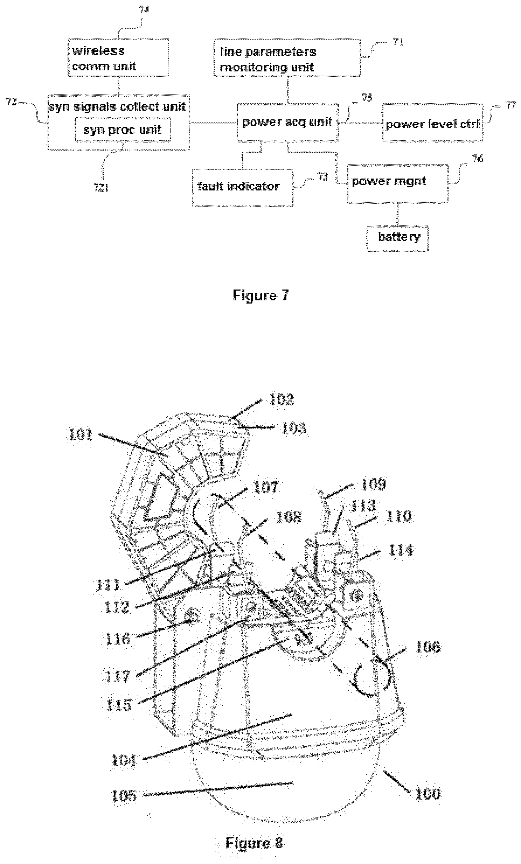

An embodiment of the present invention also provides a feeder monitoring device. The feeder monitoring device is to be installed at multiple locations on the feeder of each phase, and its specific structure is as shown in Fig. 7, and may specifically comprise:
a feeder parameter monitoring module 71 configured to detect and pick up voltage signals and current signals at multiple locations on a feeder of each phase, respectively, and extract and determine corresponding transient voltage signals and transient current signals according to the voltage signals and the current signals, and notify a synchronous signal picking-up module 72 in the feeder monitoring device on the feeder of an adjacent phase when monitoring that extents of variation in the transient voltage signals and the transient current signals exceed preset thresholds; and
a synchronous signal picking-up module 72 configured to receive a notification from a feeder parameter monitoring module in the feeder monitoring device on the feeder of the adjacent phase to pick up voltage signals and current signals on the feeders of various phases synchronously with the synchronous signal picking-up module in the feeder monitoring device on the feeder of the adjacent phase, i.e., achieve synchronous picking-up of the voltage signals and current signals on the feeders of three phases, and report them to a system mater station. The synchronous signal picking-up module 72 specifically comprises a synchronous processing module 721, and the synchronous processing module 721 synchronizes time through timing by a time division multiplexing wireless communication network in combination with timing by GPS, thereby enabling the synchronous signal picking-up module 72 to synchronously pick up the voltage signals and the current signals on the feeders of various phases based on the synchronized time.

Further, the device may also comprises a fault indicating module 73 configured to emit an indicating signal as a cue on a location of the fault point after the ground fault point is determined, for example, turning on a corresponding indicator lamp so that the inspector can find the location of the fault point timely. Specifically, wide-angle high brightness light-emitting diodes are used as indicator lamps to ensure omnidirectional indication by 360 degrees in a maximum hemispherical region, and combinations of different numbers of diodes, different flickering intervals and different flickering frequencies indicate different types of faults, respectively.

In the above feeder monitoring device, the corresponding feeder parameter monitoring module 71 may specifically employ a capacitive voltage sensor to pick up voltage signals and employs an electronic current sensor to pick up current signals. The electronic current sensor comprises a current transformer, and a wound Rogowski coil or a printed circuit board Rogowski coil; and the feeder parameter monitoring module 71, when monitoring that the extents of variation in the transient voltage signals and the transient current signals exceed preset thresholds, notifies the synchronous signal picking-up module 72 with an infrared, acoustical, ultrasonic or magnetic field signal as a triggering signal, and the particularly available modes of notification includes any one of:
mode 1: directly transmitting the triggering signal to the synchronous signal picking-up modules in the feeder monitoring devices on the feeders of the other two phases;
mode 2: firstly transmitting the triggering signal to the synchronous signal picking-up module in the feeder monitoring device on the feeder of one adjacent phase and then continuously transmitting the triggering signal by a feeder monitoring unit on the feeder of the adjacent phase to the feeder of the other phase to the synchronous signal picking-up module in the feeder monitoring device on the feeder of the other phase; and
mode 3: firstly transmitting the triggering signal to a communication terminal device so that the communication terminal device transmits the triggering signal to the synchronous signal picking-up modules in the feeder monitoring devices on the feeders of the other two phases.

Specifically, the above feeder monitoring device may also comprises:
a wireless communication module 74 configured to establish wireless communication with two feeder monitoring devices disposed at corresponding locations on the feeders of the other two phases in a time division multiplexing manner, and transmit feeder parameters from the two feeder monitoring devices at the corresponding locations on the feeders of the other two phases to a system master station via a wireless communication network, where the corresponding feeder parameters are the current signals and voltage signals of the feeder, or may also include other feeder parameters such as a feeder temperature.

Specifically, the above feeder monitoring device may also comprise:
an power acquiring module 75 comprising a magnetic material capable of achieving a closed magnetic circuit via a locking mechanism and configured to acquire electric energy from the feeder to supply power to the feeder monitoring device;
a power managing module 76 configured to control power acquiring module 75 to acquire electric energy from the feeder to supply power to the feeder monitoring device with a battery serving as a backup power source, i.e., control acquiring electric energy from the feeder when the feeder can supply power normally and control acquiring electric energy from the battery when the feeder cannot supply power normally to ensure normal power supply to the feeder monitoring device; and
a power controlling module 77 configured to control constant power for the power acquiring module 75 to acquire electric energy from the feeder, i.e., control the power of acquiring power from the feeder to ensure acquiring power enough for working when low current flows through the feeder and continuous acquiring electric energy without saturation when high current flows through the feeder.

For ease of understanding, the specific implementation structure of the feeder monitoring device will be described below.

Specifically, as shown in Fig. 8, it is schematic structure diagram of feeder monitoring device 100 (i.e., the feeder monitoring unit) in a state where a feeder clamping mechanism is opened for installation. A housing of the feeder monitoring device 100 is composed of an upper arm 101, a main body 104, and a transparent lower housing 105. The upper arm 101 is composed of two halves 102 and 103, with a part of an electronic current sensor being mounted in the half 102 and a part of a power acquiring device (i.e., power managing module 75 and power controlling module 76) being mounted in the half 103. The rest of the power acquiring device (including the power managing module 75), the rest of the electronic current sensor, a wirelessly synchronous triggering device (synchronous processing module 721), a wireless communication device (i.e., wireless communication module 74), a processing device (i.e. feeder parameter monitoring module 71), a fault indicating device (i.e., fault indicating module 73) are located in the main body 104. Light emitted by indicator LEDs of the fault indicating device comes out through the transparent lower housing 105, and specifically, each module may be completely encapsulated in the main body 104 with a pouring sealant.

The core of the power acquiring device of the feeder monitoring device 100 is a magnetic element with a closed magnetic circuit, such as circular-ring-shaped or other magnetic elements with similar closed magnetic circuit. The closed magnetic circuit encircles power-distribution network feeder 106, and the magnetic element is partitioned into two parts, one located in the upper arm 103 and the other located in the main body 104. The magnetic element is wound with a coil for acquiring power, and the coil is connected to a power controlling circuit (i.e., power controlling module 76). In order to enable the power acquiring device to acquire sufficient power when an extremely low current flows through the power-distribution network feeder 106, the two parts of magnetic elements are coupled by means of a locking device to form a tightly closed magnetic circuit. The locking device is composed of a locking spring located in an upper arm shaft 116, a damper and a pressing spring for the magnetic element located in the upper arm 103. The locking spring causes the upper arm to be in tight contact with the main body. The damper can retard the impact force on the upper arm in the locking process. The magnetic element in the upper arm 103 and the magnetic element in the main body 104 are in tight contact with each other by means of the pressing spring.

For a traditional power acquiring device, if it can acquire enough power for a device 100 to work when a low current flows through the power-distribution network feeder 106, it may not acquire power as the magnetic elements are saturated when a high current flows through the power-distribution network feeder 106. If the current flows through the power-distribution network feeder 106 is extremely high and the magnetic elements are unsaturated, it cannot acquire enough power for the feeder monitoring device 100 to work when a low current flows through the power-distribution network feeder 106. According to the present invention, with the power controlling circuit, enough power for the feeder monitoring device 100 to work can be acquired by the magnetic elements when a low current flows through the power-distribution network feeder 106. When the current flows through the power-distribution network feeder 106 is extremely high, the power controlling circuit may avoid the magnetic elements from being saturated so that enough power for the feeder monitoring device 100 to work can still be acquired.

A power managing device for the feeder monitoring device 100 converts the power obtained by the power acquiring device into working power for the system. Under the circumstance that the power-distribution network feeder is under a power failure and the power supply from the power acquiring device is unavailable, it is automatically switched to the backup battery for power supply. Under the circumstance that the power supply from the power acquiring device is available, it is automatically switched to the power acquiring device for power supply.

The feeder monitoring device 100 may specifically pick up voltage and temperature signals by means of a voltage-temperature integrated sensor 117. The sensor 117 is made of stainless steel and in tight contact with the power-distribution network feeder, has excellent electric and thermal conduction characteristics, and is capable of picking up the voltage signals on the feeder and also conducting heat on the feeder to a thermosensitive element.

The feeder monitoring device 100 picks up current signals by means of an electronic current sensor. The electronic current sensor may be a current transformer (CT), and may also be a wound Rogowski coil or a printed circuit board Rogowski coil. A part of the measuring magnetic circuit of the electronic current sensor is located in the upper arm 102 and the other part thereof is located in the main body 104.

The feeder monitoring device 100 is clamped on the feeder by means of a feeder clamping device, and in case of using the Rogowski coil type electronic current sensor, may allow the feeder to be located at the central location of the magnetic circuit of the Rogowski coil. The feeder clamping device for the feeder monitoring device 100 is composed of four wire clamping springs 107, 108, 109, 110, four spring pins 111, 112, 113, 114 for fixing the wire clamping springs, and a wire holder 115.

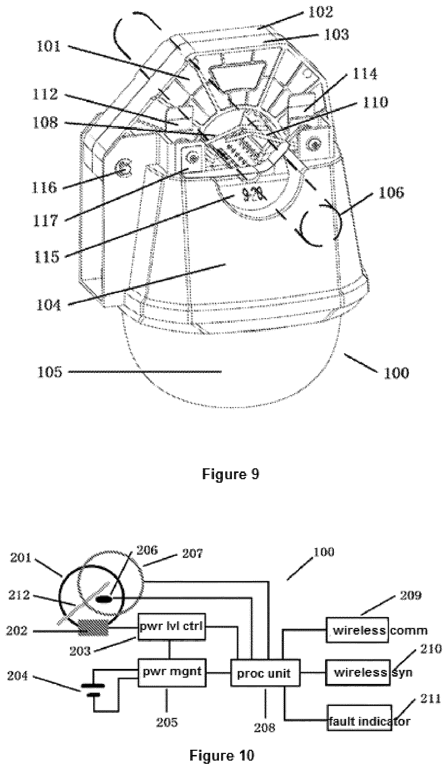

Referring to Fig. 9, it shown a schematic structure diagram of a feeder monitoring device 100 in a state where a feeder clamping mechanism is locked according to an embodiment of the present invention. In the locked state, four springs 107, 108, 109, 110 alternately and tightly hold the feeder 106 to fasten the feeder 106 on the wire hole 115, such that the two parts of magnetic elements of the power acquiring device fit closely and the feeder 106 is located at the center of the closed magnetic circuit of the electronic current sensor. The voltage-temperature integrated sensor 117 and the power-distribution network feeder 106 thus are caused to fit closely.

Another structure of the feeder monitoring device 100 constructed according to an embodiment of the present invention is as shown in Fig. 10, which comprises: a power acquiring coil 202 wound around a magnetic power acquiring element 201, and feeder 212 located at the center of the magnetic circuit of the magnetic element, where the power acquiring coil 202 is connected to a power controlling device 203 (i.e., power controlling module 76), and a battery 204 and a power controlling circuit 203 of the power acquiring device are connected to a power managing device 205 (i.e., power managing module 75). The power managing device 205 converts the power output by the power controlling circuit 203 of the power acquiring device and that by the battery 204 into power needed by a feeder monitoring device 100, and meanwhile, switches the power between the power controlling circuit 203 and the battery 204.

A processing device 208 (i.e., feeder parameter monitoring module 71) collects voltage signals picked up by a voltage-temperature integrated sensor 206, performs band-pass processing on the voltage signals to obtain transient voltage signals, extracts amplitudes, average values, differential values or integral values and combinations thereof of the transient voltage signals, and triggers a suspected ground fault alarm when the variation in one or more of the above values exceeds a set threshold.

The processing device 208 collects current signals picked up by an electronic current sensor 207, performs band-pass processing on the current signals to obtain transient current signals, extracts amplitudes, average values, differential values or integral values and combinations thereof of the transient current signals, and triggers a suspected ground fault alarm when the variation in one or more of the above values exceeds a set threshold.

The processing device 208 immediately triggers the feeder monitoring device 100 of other phases by means of a wirelessly synchronous triggering device 210 after trigging the suspected ground fault alarm.

The processing device 208 is in wireless communication with the external in a time division multiplexing manner by means of a wireless communication device 209, and performs synchronous timing to ensure that the feeder monitoring device 100 of any phase is in time synchronization with the feeder monitoring units or feeder monitoring devices 100 of the other phases.

The feeder monitoring device 100 also comprises a fault indicating device 211 (i.e., fault indicating unit) configured to indicate a locally occurring ground fault.

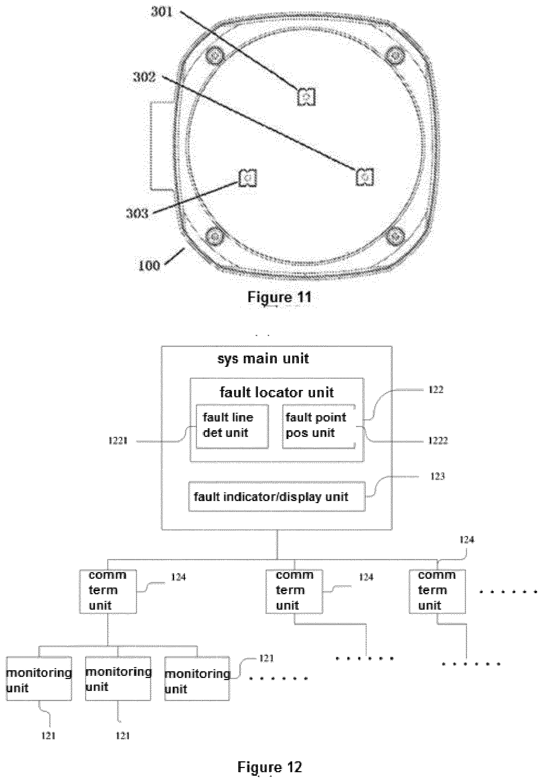

A fault indicating device of the feeder monitoring device 100 constructed according to an embodiment of the present invention is as shown in Fig. 11. The fault indicating device may be constituted by three wide-angle high brightness light-emitting diodes 301, 302 and 303 arranged at equal intervals of 120 degrees. After ground fault signals are received, different frequencies and different flickering modes are adopted to indicate different types of ground faults. An embodiment of the present invention also provides a system for detecting and locating a single-phase ground fault on a low current grounded power-distribution network, and its specific implementation structure is as shown in Fig. 12, which may specifically comprises the above-described feeder monitoring device 121 and a fault locating unit 122.

The fault locating unit 122 is configured to calculate corresponding zero-sequence voltages and zero-sequence currents according to voltage signals and current signals that are synchronously picked up at multiple locations on feeders of three phases, extract steady-state signals and transient signals of the zero-sequence voltages and the zero-sequence currents at various locations on the feeders of three phases, and determine a faulty line according to the steady-state signals of the zero-sequence voltages and the zero-sequence currents, and determine a specific fault location on the faulty line according to the transient signals of the zero-sequence voltages and the zero-sequence currents. The fault locating unit may specifically be disposed at a system master station. The system master station communicates with the feeder monitoring device through remote communication, and a one-to-many communication networking mode is adopted between the system master station and the feeder monitoring devices.

Specifically, the fault locating unit may comprise:
a faulty line locating module 1221 configured to extract the steady-state signals of the zero-sequence voltages and the zero-sequence currents at various locations, calculate characteristic values of the steady-state signals, the characteristic values including: one or more of amplitude, average value, differential value and integral value, and steady-state zero-sequence active power and steady-state zero-sequence reactive power at each location, also calculate waveform similarities between the steady-state zero-sequence voltage and zero-sequence current signals at various locations, and then screen out and determine the faulty line according to differences in the characteristic values and the waveform similarities of the steady-state signals on lines of various phases; and
a fault point locating module 1222 configured to extract the previously determined transient signals of the zero-sequence voltage and the zero-sequence current at various locations on the faulty line, calculate characteristic values of the transient signals, the characteristic values including: one or more of amplitude, average value, differential value and integral value, and transient zero-sequence active power and transient zero-sequence reactive power at each location, also calculate waveform similarities between the transient zero-sequence voltage and zero-sequence current signals at various locations, and then screen out and determine a ground fault point on the faulty line according to differences in the characteristic values and the waveform similarities of the transient signals at various locations on the faulty line, thereby achieving locating of the ground fault point.

Further, the system may also comprises a fault point displaying and indicating processing unit 123 disposed in the system system master station, and configured to display the ground fault point on a map of a Geographic Information System (GIS) after determining the ground fault point, and distribute a ground fault signal via a wireless communication network to a fault indicating unit at the ground fault point to display the fault, so that the point of the ground fault can be displayed at the system master station and the local occurrence of the ground fault can also be indicated at the location of the ground fault, allowing an inspector to find the location of the fault point conveniently.

For the sake of convenience for communication between the feeder monitoring device and the system master station, the system may also comprises a communication terminal device 124. A corresponding communication terminal device 123 may specifically be used to achieve any of the following processing.

The corresponding communication terminal devices are used to communicate with the feeder monitoring devices, transmit monitored parameters from the feeder monitoring devices to a fault locating unit disposed in a system master station. Each communication terminal device is configured to communicate with three feeder monitoring devices disposed on the one or three groups of feeders of three phases, and wireless communication is established between the communication terminal device and each feeder monitoring device; and the communication terminal device communicates with the system master station via a wireless communication network.

The communication terminal device is used to communicate with any one of three feeder monitoring devices corresponding to the feeders of three phases and transmit monitored parameters from the feeder monitoring device to a fault locating unit disposed in a system master station and the feeder monitoring device establishes wireless communication with two feeder monitoring devices disposed at the corresponding locations on the feeders of the other two phases in a time division multiplexing manner to obtain monitored parameters from the two feeder monitoring devices disposed at the corresponding locations on the feeders of the other two phases; and the communication terminal device communicates with the system master station via a wireless communication network.

That is, the monitored parameters obtained by the feeder monitoring devices can be conveniently transmitted to the system master station by means of the above-mentioned communication terminals, so that the fault locating unit in the master station can perform ground fault locating processing.

The above-described system may also comprises a feeder monitoring device having a communication terminal function, configured to establish wireless communication with two feeder monitoring devices disposed at the corresponding locations on the feeders of the other two phases in a time division multiplexing manner to obtain monitored parameters from the two feeder monitoring devices disposed at the corresponding locations on the feeders of the other two phases. The feeder monitoring device having the communication terminal function communicates with the system master station via a wireless communication network and transmitting the monitored parameters of the phases of three phases to a fault locating unit disposed in a system master station. Based on the above-descried system for detecting and locating a single-phase ground fault on a low current grounded power-distribution network, the processing procedures of detecting and locating a single-phase ground fault on a low current grounded power-distribution network provided by the embodiments of the present inventions may specifically include the following steps:
At step 1, the feeder monitoring units (i.e., feeder monitoring devices) are installed on the feeders of three phases of the power-distribution network, and the feeder monitoring units acquire power from the feeders with the acquiring power being controlled, with a battery serving as a standby power source.
At step 2, the feeder monitoring units pick up voltage signals of each phase by means of capacitive voltage sensors, and pick up current signals of each phase by means of electronic current sensors.
At step 3, the feeder monitoring unit of each phase performs band-pass processing on the picked-up voltage signals and current signals, extracts transient voltage signals and current signals, and calculates amplitudes, average values, differential values or integral values and combinations thereof of the transient voltage signals and current signals, and triggers a suspected ground fault alarm when the variation in one or more of the above values exceeds a set threshold.
At step 4, after triggering the suspected ground fault alarm, the feeder line monitoring unit disposed on the feeder of the fault phase notifies the other two phases of uploading voltage and current waveform data through wirelessly synchronous triggering (i.e., a triggering signal).
At step 5, synchronizing time through timing by a time division multiplexing wireless communication network in combination with timing by GPS, and synchronously picking up the voltage signals and the current signals at multiple locations on the feeders of three phases based on the synchronized time.
At step 6, calculate corresponding zero-sequence voltages and zero-sequence currents according to voltage signals and current signals that are synchronously picked up at multiple locations on feeders of three phases.
At step 8 Extract steady-state signals and transient signals of the zero-sequence voltages and the zero-sequence currents at various locations on the feeders of three phases, and determine a faulty line according to the steady-state signals of the zero-sequence voltages and the zero-sequence currents, and determine a specific fault location on the faulty line according to the transient signals of the zero-sequence voltages and the zero-sequence currents.

Or, the corresponding communication terminal devices are used to communicate with the feeder monitoring devices, transmit monitored parameters from the feeder monitoring devices to a fault locating unit disposed in a system master station. Each communication terminal device is configured to communicate with three feeder monitoring devices disposed on the one or three groups of feeders of three phases, and wireless communication is established between the communication terminal device and each feeder monitoring device; and the communication terminal device communicates with the system master station via a wireless communication network.

The communication terminal device is used to communicate with any one of three feeder monitoring devices corresponding to the feeders of three phases and transmit monitored parameters from the feeder monitoring device to a fault locating unit disposed in a system master station and the feeder monitoring device establishes wireless communication with two feeder monitoring devices disposed at the corresponding locations on the feeders of the other two phases in a time division multiplexing manner to obtain monitored parameters from the two feeder monitoring devices disposed at the corresponding locations on the feeders of the other two phases; and the communication terminal device communicates with the system master station via a wireless communication network.

The above-described system may also comprises a feeder monitoring device having a communication terminal function, configured to establish wireless communication with two feeder monitoring devices disposed at the corresponding locations on the feeders of the other two phases in a time division multiplexing manner to obtain monitored parameters from the two feeder monitoring devices disposed at the corresponding locations on the feeders of the other two phases. The feeder monitoring device having the communication terminal function communicates with the system master station via a wireless communication network and transmitting the monitored parameters of the phases of three phases to a fault locating unit disposed in a system master station. Based on the above-descried system for detecting and locating a single-phase ground fault on a low current grounded power-distribution network, the processing procedures of detecting and locating a single-phase ground fault on a low current grounded power-distribution network provided by the embodiments of the present inventions may specifically include the following steps:
In the above system, the system master station synchronizes time through timing by a time division multiplexing wireless communication network in combination with timing by GPS, and synchronously picks up the voltage signals and the current signals at multiple locations on the feeders of three phases based on the synchronized time.

For ease of understanding, in conjunction with the following figures, the said system ground fault location process is described in detail.

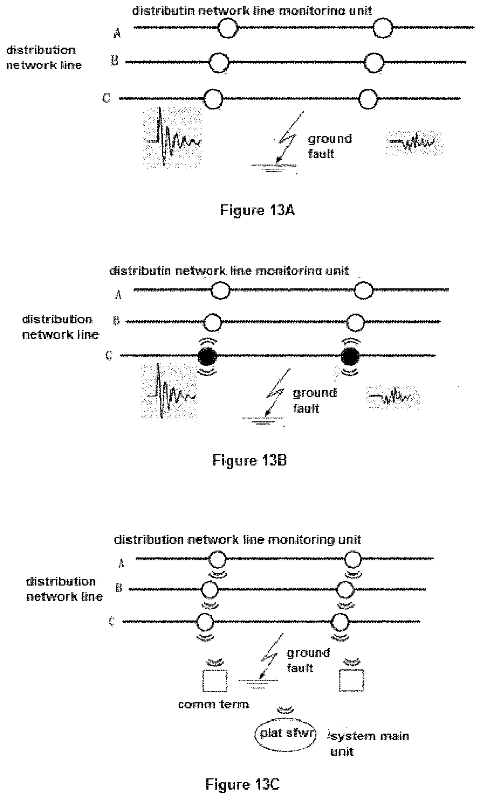

As illustrated in Fig. 13A, when a low current grounded distribution feeder with a single-phase ground fault occurs, during the ground fault transient process, the voltage and current on both sides of the ground fault variation dramatically within a very short period of time, and produce abnormal transient voltage and current signals.

The system's distribution network feeder monitoring units use capacitive voltage sensors, thus do not produce PT (voltage transformer) ferromagnetic resonance problems, therefore, they can reliably pick up the transient voltage signals. The system feeder monitoring units use electronic current sensors for current measurement, with high accuracy and good linearity, so that the measurement of low currents and large currents would have a high precision. In case of large current, because it is not saturated, transient characteristics are good, therefore, the units can reliably pick up the transient current signal. Thus, in the single-phase ground fault transient process of a low current grounded distribution feeder, because in the faulty phase the distribution feeder monitoring units use the capacitive voltage sensors and the electronic current sensors, they can detect anomalies in the transient voltage signals and the transient current signals.

As illustrated in Fig. 13B, in the distribution network faulty phase (i.e. C phase), after the feeder monitoring unit detects the suspected ground fault, it synchronously triggers (by sending a trigger signal to trigger) through wireless, a synchronized upload of the monitored voltage and current waveform data, from other phases' feeder monitoring units. Referring to Fig. 13B, after a ground fault occurs at a C phase location, the adjacent two C phase feeder ground fault monitoring units will detect the suspected ground fault, and will send to at their respective corresponding locations of the other two phases (i.e., A and B phase) those feeder monitoring units, the trigger signal.

As illustrated in Fig. 13C, a three-phase distribution feeder monitoring units can transmit the voltage and current waveform data via wireless communication. Specifically, the voltage and current waveform data of the three-phase feeder monitoring unit scan be transmitted to the communication terminal, or by way of first converge the voltage and current waveform data elements from two of the three-phase feeder monitoring units to the third phase feeder monitoring unit, follow by using the communication terminal or that feeder monitoring unit to upload the voltage and current waveform data to the system central unit's platform software, in order for the system central unit's platform software to perform the corresponding ground fault point locating processing.

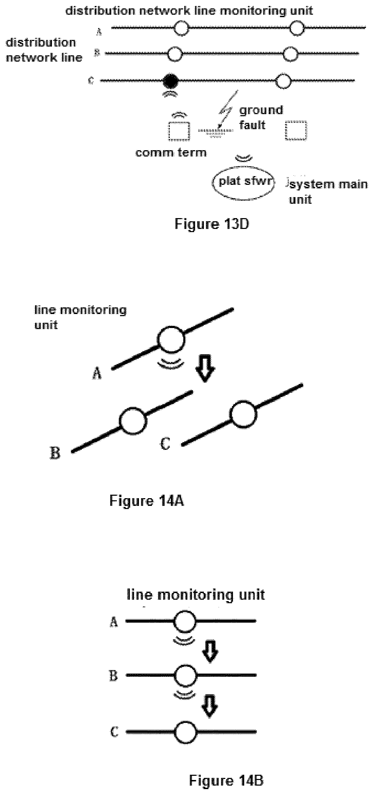

As illustrated in Fig. 13D, the system central unit's platform software performs the fault detection and location, and issues the ground fault signal to indicate the fault location, with the following specific procedures:
(1) After obtaining from the three-phase feeder monitoring units at multiple locations the voltage and current waveform data, calculate the zero-sequence voltage and zero-sequence current waveform;
(2) At the system central unit's platform software, from the calculated zero-sequence voltage and zero-sequence current at each location, extract at each location the zero-sequence voltage and zero-sequence current for the steady state signals, calculate the characteristic values, with the characteristic values include: amplitude, average, differential value, integral value and a combination thereof; also calculate the steady zero sequence active power, zero-sequence reactive power; calculate further the steady-state waveform similarity of the zero-sequence voltage and zero-sequence current signals; and based on differences in the steady-state zero-sequence voltage, zero-sequence current characteristic values and waveform similarity between fault line and non-fault lines, perform selection of the fault line and non-fault lines;
(3) At the system central unit's platform software, from the calculated zero-sequence voltage and zero-sequence current at each location, extract at each location the zero-sequence voltage and zero-sequence current for the transient signals, calculate the characteristic values, with the characteristic values include: amplitude, average, differential value, integral value and a combination of those; also calculate the steady zero sequence active power, zero-sequence reactive power; calculate further the transient state waveform similarity of the zero-sequence voltage and zero-sequence current signals; and based on the before fault and after fault locations the differences in the transient zero-sequence voltage, zero-sequence current characteristic values and waveform similarity, analyze for each location, especially with priority for selected locations at the suspected fault line, to determine the ground fault point;
(4) After the system central unit's platform software locating the ground fault point, the result can be set to have a manual secondary review(i.e., manual review by a manual review interface) to further accurately determine the final ground fault location. The result is displayed on the GIS map for the ground fault point. At the same time the system central unit's platform software system by time division multiplexing wireless communication network, issues a ground fault signal to the feeder monitoring unit to indicate the ground fault, so to conveniently allow manual line trace to locate the ground fault location.

Through the above steps (1) through (4) of the process, it can easily and accurately achieve power distribution feeder network ground fault locating with precision.

Before the system central unit conducts the ground fault locating process, referring to FIG. 13B, the feeder distribution network fault monitoring unit will detect the suspected ground fault. At that time, it can be synchronized to trigger the other phase feeder monitoring units to synchronously upload wirelessly the monitored voltage and current waveform data.

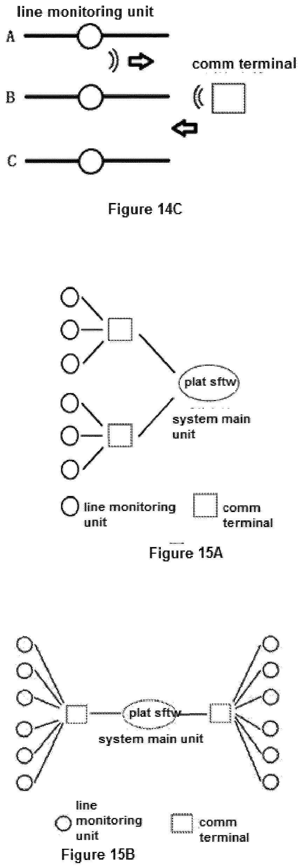

The synchronization process wirelessly triggered by the corresponding feeder monitoring unit specifically can use infrared, sound, ultrasonic, magnetic or electromagnetic field, with any one or combination thereof, sent a trigger signal to the other two phases. At the same time, that first feeder monitoring unit can also receive wireless synchronization trigger signal. The wireless synchronization trigger may include the following types:
(1) As shown in Fig. 14A, assume that the A-phase feeder monitoring unit detects the suspected ground fault, the A-phase feeder monitoring unit via a synchronous wireless triggering device, triggers synchronously the B-phase feeder monitoring unit and the C-phase feeder monitoring unit;
(2) As shown in Fig. 14B, assume that the A-phase feeder monitoring unit detects the suspected ground fault, the A-phase feeder monitoring unit via a synchronous wireless triggering device, triggers synchronously the B-phase feeder monitoring unit, and follows by the B-phase feeder monitoring unit triggers synchronously via wireless the feeder monitoring unit;
(3) As shown in Fig. 14C, assume that the A-phase feeder monitoring unit detects the suspected ground fault, the A-phase feeder monitoring unit via a synchronous wireless triggering device, triggers synchronously the communication terminal, follows by the communication terminal triggers synchronously via wireless the B-phase feeder monitoring unit and the C-phase feeder monitoring unit.

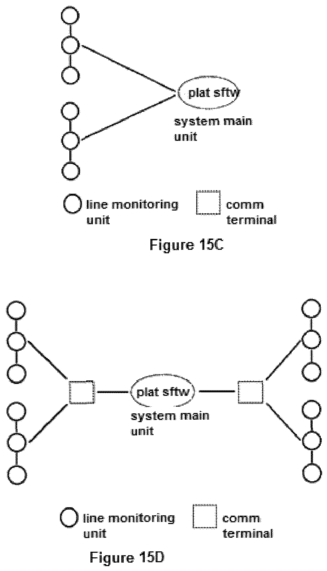

The topology structure of the system according to an embodiment of the present invention can be referred to Fig. s 15A to 15D, wherein:
Structure I: As shown in Fig. 15A, the corresponding system topology comprises: the feeder monitoring units, the communication terminal and the system central unit. Each communication terminal is connected to a set of three-phase feeder monitoring units. The communication terminal and the three-phase feeder monitoring units communicate using time-division multiplexing wireless communication, forming a wireless communication network. The communication terminal and the system central unit communicate over GSM / GPRS, CDMA, and WIFI Ethernet. The system central unit and the communication terminals are using GPS timing. The communication terminal and the feeder monitoring units use time division multiplexing wireless communication network to synchronize time, so to finally achieve precisely synchronized system timing.
Structure II: As shown in Fig. 15B, the corresponding system topology comprises: the feeder monitoring units, the communication terminal and the system central unit. Each communication terminal is connected to multiple sets of the three-phase feeder monitoring units, with Fig. 15B showing the communication terminal is connected to two sets of the three-phase feeder monitoring units. The communication terminal and the multiple sets of three-phase feeder monitoring units communicate using time-division multiplexing wireless communication, forming a wireless communication network. The communication terminal and the system central unit communicate over GSM / GPRS, CDMA, and WIFI Ethernet. The system central unit and the communication terminals are using GPS timing. The communication terminal and the feeder monitoring units use time division multiplexing wireless communication network to synchronize time, so to finally achieve precisely synchronized system timing.
Structure III: As shown in Fig. 15C, the corresponding system topology comprises: the feeder monitoring units, and the system central unit. One of the three-phase monitoring units such as B-phase unit would also function as a communication terminal, and communicates to the other two phase feeder monitoring units using time-division multiplexing wireless communication, forming a wireless communication network. This feeder monitoring unit and the system central unit communicate over GSM / GPRS, CDMA, and WIFI Ethernet. The system central unit and the communication terminals are using GPS timing. This communication terminal/feeder monitoring unit and the other feeder monitoring units use time division multiplexing wireless communication network to synchronize time, so to finally achieve precisely synchronized system timing. Structure IV: As shown in Fig. 15D, the corresponding system topology comprises: the feeder monitoring units, the communication terminal and the system central unit. One of the three-phase monitoring units such as B-phase unit communicates to the other two phase feeder monitoring units using time-division multiplexing wireless communication, forming a wireless communication network. At the same time, this feeder monitoring unit and the communication terminal communicate on another frequency, using time-division multiplexing wireless communication, forming another wireless communication network. Each communication terminal is connected to multiple feeder monitoring units, with Fig. 15D showing the communication terminal is connected to two the feeder monitoring units. The communication terminal and the system central unit communicate over GSM / GPRS, CDMA, and WIFI Ethernet. The system central unit and the communication terminals are using GPS timing. The communication terminal and the feeder monitoring units use time division multiplexing wireless communication network to synchronize time, so to finally achieve precisely synchronized system timing.

With a system based on any of the above structure, the system central unit's platform software can collect at each location in the three-phase distribution network, from the feeder monitoring units, for the voltage and the current waveform data. It then can calculate for each location the zero-sequence voltage and zero-sequence current. The system central unit's platform software, from the calculated zero-sequence voltage and zero-sequence current at each location, can extract at each location the zero-sequence voltage and zero-sequence current for the steady state signals, calculate the characteristic values, with the characteristic values include: amplitude, average, differential value, integral value and a combination thereof; also calculate the steady zero sequence active power, zero-sequence reactive power; calculate further the steady-state waveform similarity of the zero-sequence voltage and zero-sequence current signals; and based on differences in the steady-state zero-sequence voltage, zero-sequence current characteristic values and waveform similarity for fault line and non-fault lines, perform selection of the fault line and non-fault lines.

The system central unit's platform software, from the calculated zero-sequence voltage and zero-sequence current at each location, can extract at each location the zero-sequence voltage and zero-sequence current for the transient signals, calculate the characteristic values, with the characteristic values include: amplitude, average, differential value, integral value and a combination thereof; also calculate the transient zero sequence active power, zero-sequence reactive power; calculate further the transient state waveform similarity of the zero-sequence voltage and zero-sequence current signals; and based on the before fault and after fault locations the differences in the transient zero-sequence voltage, zero-sequence current characteristic values and waveform similarity, analyze for each location, especially with priority for the selected locations at the suspected fault line, to determine the ground fault point.

After the system central unit's platform software locating the ground fault point, the result can set to have a manual secondary review to conclusively determine the final ground fault location. The result is displayed on the GIS map for the ground fault point. At the same time the system central unit's platform software system by time division multiplexing wireless communication network, issues a ground fault signal to the feeder monitoring unit to indicate the ground fault, so to conveniently allow manual line tracing to locate the ground fault location.

## Claims

1. A method for detecting and locating a single-phase ground fault on a low current grounded power-distribution network, comprising:
detecting and picking up voltage signals and current signals at multiple locations on feeders of various phases, respectively, and
extracting and determining corresponding transient voltage signals and transient current signals according to the voltage signals and the current signals;
synchronously picking up voltage signals and current signals at multiple locations on the feeders of three phases when extents of variation in the transient voltage signals and the transient current signals exceed preset thresholds;
calculating corresponding zero-sequence voltages and zero-sequence currents according to the voltage signals and the current signals that are synchronously picked up at multiple locations on the feeders of three phases;
extracting steady-state signals and transient signals of the zero-sequence voltages and the zero-sequence currents at various locations on the feeders of three phases, and determining a faulty line according to the steady-state signals of the zero-sequence voltages and the zero-sequence currents; and then
determining a specific fault location on the faulty line according to the transient signals of the zero-sequence voltages and the zero-sequence currents;
wherein the step of determining a faulty line according to the steady-state signals of the zero-sequence voltages and the zero-sequence currents comprises:
extracting the steady-state signals of the zero-sequence voltages and the zero-sequence currents at various locations,
calculating characteristic values of the steady-state signals, the characteristic values including: one or more of amplitude, average value, differential value and integral value, and steady-state zero-sequence active power and steady-state zero-sequence reactive power at various locations, also
calculating waveform similarities between the steady-state zero-sequence voltage and zero-sequence current signals at various locations, and then
screening out and determining the faulty line according to differences in the characteristic values and the waveform similarities of the steady-state signals on lines of various phases; and
wherein the step of determining a specific fault location on the faulty line according to the transient signals of the zero-sequence voltages and the zero-sequence currents comprises:
extracting the previously determined transient signals of the zero-sequence voltage and the zero-sequence current at various locations on the faulty line,
calculating characteristic values of the transient signals, the characteristic values including: one or more of amplitude, average value, differential value and integral value, and transient zero-sequence active power and transient zero-sequence reactive power at each location, also
calculating waveform similarities between the transient zero-sequence voltage and zero-sequence current signals at various locations, and then
screening out and determining a ground fault point on the faulty line according to differences in the characteristic values and the waveform similarities of the transient signals at various locations on the faulty line.

2. The method of claim 1, **characterized in that** the extents of variation in the transient voltage signals and the transient current signals include:
extents of variation in the transient voltage signals and current signals calculated and determined each time in one or more of amplitude, average value, differential value and integral value.

3. The method of claim 1, **characterized in that** the step of synchronously picking up voltage signals and the current signals at multiple locations on the feeders of three phases comprises:
synchronizing time through timing by a time division multiplexing wireless communication network in combination with timing by GPS, and synchronously picking up the voltage signals and the current signals at multiple locations on the feeders of three phases based on the synchronized time.

4. The method of claim 1, **characterized by** also comprising:
displaying the ground fault point on a map of a Geographic Information System (GIS) after determining the ground fault point, and distributing a ground fault signal via a wireless communication network to a fault indicating unit at the ground fault point to display the fault.

5. A system for detecting and locating a single-phase ground fault on a low current grounded power-distribution network, the system comprising a plurality of feeder monitoring devices (100, 121) provided at multiple locations on feeders of various phases
wherein the plurality of feeder monitoring devices (100, 121) are configured to
detect and pick up voltage signals and current signals at the multiple locations on the feeders of the various phases, respectively;
extract and determine corresponding transient voltage signals and transient current signals according to the voltage signals and the current signals; and
synchronously pick up voltage signals and current signals at the multiple locations on the feeders of three phases when extents of variation in the transient voltage signals and the transient current signals exceed preset thresholds;
wherein each feeder monitoring device (100, 121) comprises:
a feeder parameter monitoring module (71) configured to detect and pick up voltage signals and current signals at a location on a feeder of a phase, and extract and determine a corresponding transient voltage signal and transient current signal according to the voltage signals and the current signals, and notify a synchronous signal picking-up module in a feeder monitoring device on a feeder of an adjacent phase when monitoring that extents of variation in the transient voltage signal and the transient current signal exceed preset thresholds; and
a synchronous signal picking-up module (72) configured to receive a notification from a feeder parameter monitoring module (71) in a feeder monitoring device on a feeder of an adjacent phase to pick up voltage signals and current signals on a feeder of a phase synchronously with the synchronous signal picking-up module (72) in the feeder monitoring device on the feeder of the adjacent phase, and report the picked-up signals;
wherein the system further comprises a fault locating unit (122),
wherein the fault locating unit (122) is configured to:
calculate corresponding zero-sequence voltages and zero-sequence currents according to voltage signals and current signals that are synchronously picked up at multiple locations on feeders of three phases,
extract steady-state signals and transient signals of the zero-sequence voltages and the zero-sequence currents at various locations on the feeders of three phases, and determine a faulty line according to the steady-state signals of the zero-sequence voltages and the zero-sequence currents, and
determine a specific fault location on the faulty line according to the transient signals of the zero-sequence voltages and the zero-sequence currents;
wherein the fault locating unit (122) comprises:
a faulty line locating module (1221) configured to extract the steady-state signals of the zero-sequence voltages and the zero-sequence currents at various locations, calculate characteristic values of the steady-state signals, the characteristic values including: one or more of amplitude, average value, differential value and integral value, and steady-state zero-sequence active power and steady-state zero-sequence reactive power at each location, also calculate waveform similarities between the steady-state zero-sequence voltage and zero-sequence current signals at various locations, and then screen out and determine the faulty line according to differences in the characteristic values and the waveform similarities of the steady-state signals on lines of various phases; and
a fault point locating module (1222) configured to extract the previously determined transient signals of the zero-sequence voltage and the zero-sequence current at various locations on the faulty line, calculate characteristic values of the transient signals, the characteristic values including: one or more of amplitude, average value, differential value and integral value, and transient zero-sequence active power and transient zero-sequence reactive power at each location, also calculate waveform similarities between the transient zero-sequence voltage and zero-sequence current signals at various locations, and then screen out and determine a ground fault point on the faulty line according to differences in the characteristic values and the waveform similarities of the transient signals at various locations on the faulty line.

6. The system of claim 5, **characterized in that** the synchronous signal picking-up module (72) comprises a synchronous processing module (721), and the synchronous processing module synchronizes time through timing by a time division multiplexing wireless communication network in combination with timing by GPS, thereby enabling the synchronous signal picking-up module to synchronously pick up the voltage signals and the current signals on the feeders of various phases based on the synchronized time.

7. The system of claim 5, **characterized by** also comprising:
a fault indicating module (73) configured to emit an indicating signal as a cue on a location of the fault point after the ground fault point is determined, wherein specifically, wide-angle high brightness light-emitting diodes are used as indicator lamps, and combinations of different numbers of diodes, different flickering intervals and different flickering frequencies indicate different types of faults, respectively.

8. The system of claim 5, 6 or 7, **characterized in that** the feeder parameter monitoring module employs a capacitive voltage sensor to pick up voltage signals and employs an electronic current sensor to pick up current signals; the electronic current sensor comprises a current transformer, and a wound Rogowski coil or a printed circuit board Rogowski coil; and the feeder parameter monitoring module, when monitoring that the extents of variation in the transient voltage signals and the transient current signals exceed preset thresholds, notifies the synchronous signal picking-up module in the feeder monitoring device on the feeder of the adjacent line with an infrared, acoustical, ultrasonic or magnetic field signal as a triggering signal, and the modes of notification includes:
directly transmitting the triggering signal to the synchronous signal picking-up modules in the feeder monitoring devices on the feeders of the other two phases; or
firstly transmitting the triggering signal to the synchronous signal picking-up module in the feeder monitoring device on the feeder of one adjacent phase and then continuously transmitting the triggering signal by a feeder monitoring unit on the feeder of the adjacent phase to the feeder of the other phase to the synchronous signal picking-up module in the feeder monitoring device on the feeder of the other phase; or
firstly transmitting the triggering signal to a communication terminal device so that the communication terminal device transmits the triggering signal to the synchronous signal picking-up modules in the feeder monitoring devices on the feeders of the other two phases.

9. The system of claim 5, 6 or 7, **characterized by** also comprising:
a wireless communication module (74) configured to establish wireless communication with two feeder monitoring devices disposed at corresponding locations on the feeders of the other two phases in a time division multiplexing manner, and transmit feeder parameters from the two feeder monitoring devices at the corresponding locations on the feeders of the other two phases to a system master station via a wireless communication network.

10. The system of claim 5, 6 or 7, **characterized by** also comprising:
a power acquiring module (75) comprising a magnetic material capable of achieving a closed magnetic circuit via a locking mechanism and configured to acquire electric energy from the feeder to supply power to the feeder monitoring device;
a power managing module (76) configured to control the power acquiring module (75) to acquire electric energy from the feeder to supply power to the feeder monitoring device with a battery serving as a backup power source; and
a power controlling module (77) configured to control constant power for acquiring electric energy from the feeder.

11. The system of claim 5, 6 or 7, **characterized by** also comprising a feeder clamping component composed of a spring, a wire holder and a locking mechanism and configured to clamp the feeder between the wire holder and the spring with the feeder being adjustable in location by means of the wire holder, wherein the feeder clamping component is tightly closed by means of the locking mechanism after clamping the feeder.

12. The system of any one of claims 5- 11, **characterized by** also comprising:
a fault point displaying and indicating processing unit (123) configured to display the ground fault point on a map of a Geographic Information System (GIS) after determining the ground fault point,
and distribute a ground fault signal via a wireless communication network to a fault indicating unit at the ground fault point to display the fault.

13. The system of any one of claim 5- 12, **characterized by** also comprising:
communication terminal devices (124) configured to communicate with the feeder monitoring devices, transmit monitored parameters from the feeder monitoring devices to a fault locating unit disposed in a system master station, wherein each communication terminal device is configured to communicate with three feeder monitoring devices disposed on the one or three groups of feeders of three phases, and wireless communication is established between the communication terminal device and each feeder monitoring device; and the communication terminal device communicates with the system master station via a wireless communication network; or
a communication terminal device (124) configured to communicate with any one of three feeder monitoring devices corresponding to the feeders of three phases and transmit monitored parameters from the feeder monitoring device to a fault locating unit disposed in a system master station, wherein the feeder monitoring device establishes wireless communication with two feeder monitoring devices disposed at the corresponding locations on the feeders of the other two phases in a time division multiplexing manner to obtain monitored parameters from the two feeder monitoring devices disposed at the corresponding locations on the feeders of the other two phases;
and the communication terminal device communicates with the system master station via a wireless communication network; or
a feeder monitoring device having a communication terminal function, configured to establish wireless communication with two feeder monitoring devices disposed at the corresponding locations on the feeders of the other two phases in a time division multiplexing manner to obtain monitored parameters from the two feeder monitoring devices disposed at the corresponding locations on the feeders of the other two phases, the feeder monitoring device having the communication terminal function communicating with the system master station via a wireless communication network and transmitting the monitored parameters of the phases of three phases to a fault locating unit disposed in a system master station.

## Patentansprüche

1. Verfahren zum Erkennen und Lokalisieren eines einphasigen Erdschlusses in einem geerdeten Schwachstrom-Energieverteilungsnetz, umfassend:
Erfassen und Aufnehmen von Spannungs- und Stromsignalen an mehreren Stellen auf Zuleitungen verschiedener Phasen und
Extrahieren und Bestimmen entsprechender transienter Spannungs- und Stromsignale gemäß den Spannungs- und Stromsignalen;
synchrone Erfassung von Spannungs- und Stromsignalen an mehreren Stellen der Zuleitungen von drei Phasen, wenn die Schwankungsbreite der transienten Spannungs- und Stromsignale voreingestellte Schwellenwerte überschreitet;
Berechnung der entsprechenden Null sequenzspannungen und Nullsequenz-Ströme entsprechend den Spannungs- und Stromsignalen, die an mehreren Stellen der dreiphasigen Zuleitungen synchron abgegriffen werden;
Extrahieren von stationären Signalen und transienten Signalen der Nullsequenzspannungen und der Nullsequenz-Ströme an verschiedenen Stellen auf den Zuleitungen von drei Phasen und Bestimmen einer fehlerhaften Leitung entsprechend den stationären Signalen der Nullsequenzspannungen und der Nullsequenz-Ströme; und dann
Bestimmung einer bestimmten Fehlerstelle auf der fehlerhaften Leitung anhand der transienten Signale der Nullsequenzspannungen und Nullsequenz-Ströme;
wobei der Schritt der Bestimmung einer fehlerhaften Leitung gemäß den stationären Signalen der Nullsequenzspannungen und Nullsequenz-Ströme umfasst:
Extraktion der stationären Signale der Nullsequenzspannungen und der Nullsequenz-Ströme an verschiedenen Stellen,
Berechnung charakteristischer Werte der stationären Signale, wobei die charakteristischen Werte Folgendes umfassen: eine oder mehrere Amplituden, einen Durchschnittswert, einen Differenzwert und einen Integralwert sowie die stationäre Nullsequenz-Wirkleistung und die stationäre Nullsequenz-Blindleistung an verschiedenen Stellen, außerdem
Berechnung der Ähnlichkeiten der Wellenformen zwischen den stationären Nullsequenzspannungs- und Nullsequenz-Stromsignalen an verschiedenen Stellen, und dann
Herausfiltern und Bestimmen der fehlerhaften Leitung anhand von Unterschieden in den charakteristischen Werten und den Wellenformähnlichkeiten der stationären Signale auf Leitungen verschiedener Phasen; und
wobei der Schritt der Bestimmung einer bestimmten Fehlerstelle auf der fehlerhaften Leitung anhand der transienten Signale der Nullsequenzspannungen und Nullsequenz-Ströme umfasst;
Extraktion der zuvor ermittelten transienten Signale der Nullsequenzspannung und des Nullsequenz-Stroms an verschiedenen Stellen der fehlerhaften Leitung,
Berechnung charakteristischer Werte der transienten Signale, wobei die charakteristischen Werte Folgendes umfassen: eine oder mehrere Amplituden, einen Durchschnittswert, einen Differenzwert und einen Integralwert sowie die transienten Nullsequenz-Wirkleistung und die transienten Nullsequenz-Blindleistung an jeder Stelle, außerdem
Berechnung der Ähnlichkeiten der Wellenformen zwischen den transienten Nullsequenzspannungs- und Nullsequenzstromsignalen an verschiedenen Stellen, und dann
Herausfiltern und Bestimmen eines Erdschlusspunktes auf der fehlerhaften Leitung entsprechend den Unterschieden in den charakteristischen Werten und den Wellenformähnlichkeiten der transienten Signale an verschiedenen Stellen auf der fehlerhaften Leitung.

2. Verfahren nach Anspruch 1, **dadurch gekennzeichnet, dass** die Ausmaße der Variation in den transienten Spannungs- und Stromsignalen umfassen:
Ausmaß der Schwankungen in den transienten Spannungs- und Stromsignalen, die jedes Mal als Amplitude, Mittelwert, Differenzwert oder Integralwert berechnet und bestimmt werden.

3. Verfahren nach Anspruch 1, **dadurch gekennzeichnet, dass** der Schritt des synchronen Aufnehmens von Spannungs- und Stromsignalen an mehreren Stellen auf den Zuleitungen von drei Phasen Folgendes umfasst:
Synchronisieren der Zeit durch Zeitmessung durch ein drahtloses Zeitmultiplex-Kommunikationsnetz in Kombination mit Zeitmessung durch GPS und synchrones Aufnehmen der Spannungs- und Stromsignale an mehreren Stellen auf den Zuleitungen von drei Phasen auf der Grundlage der synchronisierten Zeit.

4. Verfahren nach Anspruch 1, **dadurch gekennzeichnet, dass** es auch Folgendes umfasst:
das Anzeigen des Erdschlusspunktes auf einer Karte eines geografischen Informationssystems (GIS) nach der Bestimmung des Erdschlusspunktes und Verteilen eines Erdschluss-Signals über ein drahtloses Kommunikationsnetz an eine Fehleranzeigeeinheit am Erdschlusspunkt, um den Fehler anzuzeigen.

5. System zum Erkennen und Lokalisieren eines einphasigen Erdschlusses in einem geerdeten Schwachstrom-Energieverteilungsnetz, wobei das System eine Vielzahl von Zuleitungsüberwachungsvorrichtungen (100, 121) umfasst, die an mehreren Stellen an Zuleitungen mit verschiedenen Phasen vorgesehen sind
wobei die Mehrzahl der Zuleitungsüberwachungsvorrichtungen (100, 121) konfiguriert ist, um Spannungs- und Stromsignale an mehreren Stellen auf Zuleitungen verschiedener Phasen zu extrahieren und aufzunehmen und
entsprechende transiente Spannungs- und Stromsignale gemäß den Spannungs- und Stromsignalen zu extrahieren und zu bestimmen; und
die Spannungs- und Stromsignale an den verschiedenen Stellen der dreiphasigen Zuleitungen synchron zu erfassen, wenn die Schwankungsbreite der transienten Spannungs- und Stromsignale voreingestellte Schwellenwerte überschreitet;
wobei jede Zuleitungsüberwachungsvorrichtung (100, 121) umfasst:
ein Zuleitungsparameter-Überwachungsmodul (71), das so konfiguriert ist, dass es Spannungs-und Stromsignale an einer Stelle auf einer Zuleitung einer Phase erfasst und aufnimmt und ein entsprechendes transientes Spannungs- und Stromsignal gemäß den Spannungs- und Stromsignalen extrahiert und bestimmt und ein Synchronsignalaufnahmemodul in einer Zuleitungsüberwachungsvorrichtung auf einer Zuleitung einer benachbarten Phase benachrichtigt, wenn es überwacht, dass die Ausmaße der Variation in dem transienten Spannungs- und Stromsignal voreingestellte Schwellenwerte überschreiten; und
ein Synchronsignalaufnahmemodul (72), das so konfiguriert ist, dass es eine Benachrichtigung von einem Zuleitungsparameter-Überwachungsmodul (71) in einer Zuleitungsüberwachungsvorrichtung auf einer Zuleitung einer benachbarten Phase empfängt, um Spannungs- und Stromsignale auf einer Zuleitung einer Phase synchron mit dem Synchronsignalaufnahmemodul (72) in der Zuleitungsüberwachungsvorrichtung auf der Zuleitung der benachbarten Phase aufzunehmen und die aufgenommenen Signale zu melden;
wobei das System ferner eine Fehlerlokalisierungseinheit (122) umfasst,
wobei die Fehlerlokalisierungseinheit (122) so konfiguriert ist, dass sie:
dass es die entsprechenden Nullsequenzspannungen und Nullsequenz-Ströme anhand von Spannungs- und Stromsignalen berechnet, die synchron an mehreren Stellen auf dreiphasigen Zuleitungen aufgenommen werden,
stationäre und transiente Signale der Nullsequenzspannungen und -ströme an verschiedenen Stellen auf den Zuleitungen von drei Phasen extrahiert und eine fehlerhafte Leitung entsprechend den stationären Signalen der Nullsequenzspannung und -ströme bestimmt; und dann
eine bestimmte Fehlerstelle auf der fehlerhaften Leitung gemäß den transienten Signalen der Nullsequenzspannungen und der Nullsequenz-Ströme bestimmt;
wobei die Fehlerlokalisierungseinheit (122) umfasst:
ein Modul zur Lokalisierung fehlerhafter Leitungen (1221), das so konfiguriert ist, dass es die stationären Signale der Nullsequenzspannungen und der Nullsequenz-Ströme an verschiedenen Stellen extrahiert, charakteristische Werte der stationären Signale berechnet, wobei die charakteristischen Werte Folgendes umfassen: einen oder mehrere von Amplitude, Mittelwert, Differenzwert und Integralwert, und stationäre Nullsequenz-Wirkleistung und stationäre Nullsequenz-Blindleistung an jeder Stelle, auch Wellenformähnlichkeiten zwischen den stationären Nullsequenzspannungs- und Stromsignalen an verschiedenen Stellen zu berechnen, und dann die fehlerhafte Leitung entsprechend den Unterschieden in den charakteristischen Werten und den Wellenformähnlichkeiten der stationären Signale auf Leitungen verschiedener Phasen auszusondern und zu bestimmen; und
ein Fehlerpunktlokalisierungsmodul (1222), das so konfiguriert ist, dass es die zuvor ermittelten transienten Signale der Nullsequenzspannung und des Nullsequenzstroms an verschiedenen Stellen auf der fehlerhaften Leitung extrahiert, charakteristische Werte der transienten Signale berechnet, wobei die charakteristischen Werte Folgendes umfassen: einen oder mehrere von Amplitude, Mittelwert, Differenzwert und Integralwert, und transiente Nullsequenz-Wirkleistung und transiente Nullsequenz-Blindleistung an jedem Stelle, auch Wellenformähnlichkeiten zwischen den transienten Nullsequenz-Spannungs- und Nullsequenz-Stromsignalen an verschiedenen Stellen zu berechnen, und dann einen Erdschlusspunkt auf der fehlerhaften Leitung entsprechend den Unterschieden in den charakteristischen Werten und den Wellenformähnlichkeiten der transienten Signale an verschiedenen Orten auf der fehlerhaften Leitung auszusondern und zu bestimmen.

6. System nach Anspruch 5, **dadurch gekennzeichnet, dass** das Synchronsignalaufnahmemodul (72) ein Synchronverarbeitungsmodul (721) umfasst, und das Synchronverarbeitungsmodul die Zeit durch Zeitmessung mittels eines drahtlosen Zeitmultiplex-Kommunikationsnetzes in Kombination mit Zeitmessung durch GPS synchronisiert, wodurch das Synchronsignalaufnahmemodul in die Lage versetzt wird, die Spannungs- und Stromsignale auf den Zuleitungen verschiedener Phasen auf der Grundlage der synchronisierten Zeit synchron aufzunehmen.

7. Das System nach Anspruch 5, **dadurch gekennzeichnet, dass** es außerdem Folgendes umfasst: ein Fehleranzeigemodul (73), das so konfiguriert ist, dass es ein Anzeigesignal als Hinweis auf eine Stelle des Fehlerpunkts ausgibt, nachdem der Erdfehlerpunkt bestimmt wurde, wobei insbesondere Weitwinkel-Leuchtdioden mit hoher Helligkeit als Anzeigelampen verwendet werden und Kombinationen aus unterschiedlicher Anzahl von Dioden, unterschiedlichen Flackerintervallen und unterschiedlichen Flackerfrequenzen jeweils unterschiedliche Fehlerarten anzeigen.

8. System nach Anspruch 5, 6 oder 7, **dadurch gekennzeichnet, dass** das Zuleitungsparameter-Überwachungsmodul einen kapazitiven Spannungssensor zum Aufnehmen von Spannungssignalen und einen elektronischen Stromsensor zum Aufnehmen von Stromsignalen verwendet; wobei der elektronische Stromsensor einen Stromwandler und eine gewickelte Rogowskispule oder eine Leiterplatten-Rogowskispule umfasst; und das Zuleitungsparameter-Überwachungsmodul, wenn es überwacht, dass die Ausmaße der Variation in den transienten Spannungs- und Stromsignalen voreingestellte Schwellenwerte überschreiten, das Synchronsignalaufnahmemodul in der Zuleitungsüberwachungsvorrichtung auf der Zuleitung der benachbarten Leitung mit einem Infrarot-, Akustik-, Ultraschall- oder Magnetfeldsignal als ein Auslösesignal benachrichtigt, und die Modi der Benachrichtigung umfassen:
direkte Übertragung des Auslösesignals an die Synchronsignalaufnahmemodul in den Zuleitungsüberwachungsvorrichtungen der Zuleitungen der beiden anderen Phasen; oder
zunächst das Auslösesignal an das Synchronsignalaufnahmemodul in der Zuleitungsüberwachungsvorrichtung auf der Zuleitung einer benachbarten Phase und dann kontinuierlich das Auslösesignal durch eine Zuleitungsüberwachungseinheit auf der Zuleitung der benachbarten Phase an der Zuleitung der anderen Phase an das Synchronsignalaufnahmemodul in der Zuleitungsüberwachungsvorrichtung auf der Zuleitung der anderen Phase übertragen; oder
zunächst die Übertragung des Auslösesignals an ein Kommunikationsendgerät, so dass das Kommunikationsendgerät das Auslösesignal an die Synchronsignalaufnahmemodule in den Zuleitungsüberwachungsvorrichtungen auf den Zuleitungen der beiden anderen Phasen weiterleitet.

9. Das System nach Anspruch 5, 6 oder 7, **dadurch gekennzeichnet, dass** es auch Folgendes umfasst:
ein drahtloses Kommunikationsmodul (74), das so konfiguriert ist, dass es eine drahtlose Kommunikation mit zwei Zuleitungsüberwachungsvorrichtungen, die an entsprechenden Stellen an den Zuleitungen der anderen beiden Phasen angeordnet sind, im Zeitmultiplexverfahren herstellt und Zuleitungsparameter von den beiden Zuleitungsüberwachungsvorrichtungen an den entsprechenden Stellen an den Zuleitungen der anderen beiden Phasen über ein drahtloses Kommunikationsnetz an eine Systemzentralen überträgt.

10. Das System nach Anspruch 5, 6 oder 7, **dadurch gekennzeichnet, dass** es auch Folgendes umfasst:
ein Energieerfassungsmodul (75), das ein magnetisches Material umfasst, das in der Lage ist, über einen Verriegelungsmechanismus einen geschlossenen magnetischen Kreis zu bilden, und das so konfiguriert ist, dass es elektrische Energie von der Zuleitung erfasst, um die Zuleitungsüberwachungsvorrichtung mit Energie zu versorgen;
ein Energieverwaltungsmodul (76), das so konfiguriert ist, dass es das Energieerfassungsmodul (75) so steuert, dass es elektrische Energie von der Zuleitung erfasst, um die Zuleitungsüberwachungsvorrichtung mit Energie zu versorgen, wobei eine Batterie als Reserveenergiequelle dient; und
ein Leistungssteuerungsmodul (77), das so konfiguriert ist, dass es eine konstante Leistung zur Gewinnung elektrischer Energie von der Zuleitung steuert.

11. System nach Anspruch 5, 6 oder 7, **dadurch gekennzeichnet, dass** es auch eine Zuleitungs-Klemmkomponente umfasst, die aus einer Feder, einem Drahthalter und einem Verriegelungsmechanismus besteht und so konfiguriert ist, dass sie die Zuleitung zwischen dem Drahthalter und der Feder festklemmt, wobei die Position der Zuleitung mittels des Drahthalters einstellbar ist, wobei die Zuleitungs-Klemmkomponente nach dem Festklemmen der Zuleitung mittels des Verriegelungsmechanismus dicht geschlossen wird.

12. Das System nach einem der Ansprüche 5-11, **dadurch gekennzeichnet, dass** es auch Folgendes umfasst:
eine Fehlerpunktanzeige- und -anzeigeverarbeitungseinheit (123), die so konfiguriert ist, dass sie den Erdfehlerpunkt auf einer Karte eines geografischen Informationssystems (GIS) nach der Bestimmung des Erdfehlerpunkts anzeigt und ein Erdfehlersignal über ein drahtloses Kommunikationsnetz an eine Fehleranzeigeeinheit am Erdfehlerpunkt verteilt, um den Fehler anzuzeigen.

13. Das System nach einem der Ansprüche 5-12, **dadurch gekennzeichnet, dass** es auch Folgendes umfasst:
Kommunikationsendgeräte (124), die so konfiguriert sind, dass sie mit den Zuleitungsüberwachungsvorrichtungen kommunizieren, überwachte Parameter von den Zuleitungsüberwachungsvorrichtungen an eine Fehlerlokalisierungseinheit übertragen, die in einer Systemzentrale angeordnet ist, wobei jedes Kommunikationsendgerät so konfiguriert ist, dass es mit drei Zuleitungsüberwachungsvorrichtungen kommuniziert, die an der einen oder den drei Gruppen von Zuleitungen von drei Phasen angeordnet sind, und eine drahtlose Kommunikation zwischen dem Kommunikationsendgerät und jeder Zuleitungsüberwachungsvorrichtung hergestellt wird; und
das Kommunikationsendgerät mit der Systemzentrale über ein drahtloses Kommunikationsnetzwerk kommuniziert; oder
ein Kommunikationsendgerät (124), das so konfiguriert ist, dass es mit einer beliebigen von drei Zuleitungsüberwachungsvorrichtungen, die den Zuleitungen von drei Phasen entsprechen, kommuniziert und überwachte Parameter von der Zuleitungsüberwachungsvorrichtung an eine Fehlerlokalisierungseinheit überträgt, die in einer Systemzentrale angeordnet ist, wobei die Zuleitungsüberwachungsvorrichtung eine drahtlose Kommunikation mit zwei Zuleitungsüberwachungsvorrichtungen, die an den entsprechenden Stellen an den Zuleitungen der anderen zwei Phasen angeordnet sind, in einer Zeitmultiplexweise herstellt, um überwachte Parameter von den zwei Zuleitungsüberwachungsvorrichtungen zu erhalten, die an den entsprechenden Stellen an den Zuleitungen der anderen zwei Phasen angeordnet sind; und die Kommunikationsendeinrichtung mit der Systemzentrale über ein drahtloses Kommunikationsnetzwerk kommuniziert; oder
eine Zuleitungsüberwachungsvorrichtung mit einer Kommunikationsendstellenfunktion, die so konfiguriert ist, dass sie eine drahtlose Kommunikation mit zwei Zuleitungsüberwachungsvorrichtungen herstellt, die an den entsprechenden Stellen auf den Zuleitungen der anderen zwei Phasen in einer Zeitmultiplexweise angeordnet sind, um überwachte Parameter von den zwei Zuleitungsüberwachungsvorrichtungen zu erhalten, die an den entsprechenden Stellen auf den Zuleitungen der anderen zwei Phasen angeordnet sind, wobei die Zuleitungsüberwachungsvorrichtung mit der Kommunikationsendstellenfunktion mit der Systemzentrale über ein drahtloses Kommunikationsnetz kommuniziert und die überwachten Parameter der Phasen von drei Phasen an eine Fehlerlokalisierungseinheit überträgt, die in einer Systemzentrale angeordnet ist.

## Revendications

1. Le présent procédé permet de détecter et de localiser un défaut de mise à la terre monophasé sur un réseau de distribution d'énergie mis à la terre à faible courant, comprenant :
la détection et le captage de signaux de tension et de signaux de courant en de multiples emplacements sur des lignes d'alimentation de diverses phases, respectivement, et
l'extraction et la détermination de signaux de tension transitoires et de signaux de courant transitoires correspondants en fonction des signaux de tension et des signaux de courant ;
la saisie synchrone de signaux de tension et de signaux de courant en de multiples emplacements sur les lignes d'alimentation de trois phases lorsque les étendues de la variation des signaux de tension transitoires et des signaux de courant transitoires dépassent des seuils prédéfinis ;
le calcul de tensions homopolaires et de courants homopolaires correspondants en fonction des signaux de tension et des signaux de courant qui sont détectés de manière synchrone en de multiples emplacements sur les lignes d'alimentation de trois phases ;
l'extraction des signaux en régime permanent et des signaux transitoires des tensions homopolaires et des courants homopolaires en divers emplacements sur les lignes d'alimentation triphasées, et la détermination d'une ligne défectueuse en fonction des signaux en régime permanent des tensions homopolaires et des courants homopolaires ; puis la
détermination d'un emplacement de défaut spécifique sur la ligne défectueuse en fonction des signaux transitoires des tensions homopolaires et des courants homopolaires ;
dans lequel l'étape de détermination d'une ligne défectueuse selon les signaux en régime permanent des tensions homopolaires et des courants homopolaires comprend :
l'extraction des signaux en régime permanent des tensions homopolaires et des courants homopolaires à divers emplacements,
le calcul des valeurs caractéristiques des signaux en régime permanent, les valeurs caractéristiques comprenant : une ou plusieurs valeurs parmi l'amplitude, la valeur moyenne, la valeur différentielle et la valeur intégrale, et la puissance active homopolaire de régime permanent et la puissance réactive homopolaire de régime permanent à divers emplacements, également
calculer les similitudes de forme d'onde entre les signaux de tension homopolaire de régime permanent et de courant homopolaire de régime permanent à divers emplacements, puis
en éliminant et en déterminant la ligne défectueuse en fonction des différences entre les valeurs caractéristiques et les similitudes de forme d'onde des signaux en régime permanent sur les lignes de diverses phases ; et
dans lequel l'étape consistant à déterminer un emplacement de défaut spécifique sur la ligne défectueuse en fonction des signaux transitoires des tensions homopolaires et des courants homopolaires comprend :
l'extraction des signaux transitoires précédemment déterminés de la tension homopolaire et du courant homopolaire à divers emplacements sur la ligne défectueuse,
le calcul des valeurs caractéristiques des signaux transitoires, les valeurs caractéristiques comprenant : une ou plusieurs valeurs parmi l'amplitude, la valeur moyenne, la valeur différentielle et la valeur intégrale, et la puissance active homopolaire transitoire et la puissance réactive homopolaire transitoire à chaque emplacement, également
en calculant les similitudes de forme d'onde entre les signaux transitoires de tension homopolaire et de courant homopolaire à divers emplacements, puis
en sélectionnant et en déterminant un point de défaut à la terre sur la ligne défectueuse en fonction des différences entre les valeurs caractéristiques et les similitudes de forme d'onde des signaux transitoires à divers emplacements sur la ligne défectueuse.

2. Le procédé de la revendication 1, **caractérisé en ce que** les étendues de la variation des signaux de tension transitoire et des signaux de courant transitoire comprennent :
des étendues de variation des signaux de tension transitoires et des signaux de courant calculées et déterminées chaque fois dans un ou plusieurs des éléments suivants : amplitude, valeur moyenne, valeur différentielle et valeur intégrale.

3. Le procédé de la revendication 1, **caractérisé en ce que** l'étape consistant à capter de manière synchrone les signaux de tension et les signaux de courant à des emplacements multiples sur les lignes d'alimentation de trois phases comprend :
la synchronisation du temps par le biais d'une synchronisation par un réseau de communication sans fil à multiplexage par répartition dans le temps en combinaison avec une synchronisation par GPS, et le captage synchrone des signaux de tension et des signaux de courant en de multiples emplacements sur les lignes d'alimentation de trois phases sur la base du temps synchronisé.

4. Le procédé de la revendication 1, **caractérisé en ce qu'**il comprend également :
l'affichage du point de défaut à la terre sur une carte d'un système d'information géographique (GIS) après avoir déterminé le point de défaut à la terre, et la distribution d'un signal de défaut à la terre via un réseau de communication sans fil à une unité d'indication de défaut au point de défaut à la terre pour afficher le défaut.

5. Un système pour détecter et localiser un défaut de terre monophasé sur un réseau de distribution d'énergie mis à la terre à faible courant, le système comprenant une pluralité de dispositifs de surveillance de lignes d'alimentation (100, 121) prévus à de multiples emplacements sur des lignes d'alimentation de diverses phases,
dans lequel la pluralité de dispositifs de surveillance de lignes d'alimentation (100, 121) sont configurés pour
détecter et capter des signaux de tension et des signaux de courant aux multiples emplacements sur les lignes d'alimentation des diverses phases, respectivement ;
extraire et déterminer des signaux de tension transitoires et des signaux de courant transitoires correspondants selon les signaux de tension et les signaux de courant ; et
capter de manière synchrone les signaux de tension et les signaux de courant aux multiples emplacements sur les lignes d'alimentation des trois phases lorsque les étendues de la variation des signaux de tension transitoire et des signaux de courant transitoire dépassent des seuils prédéfinis ;
dans lequel chaque dispositif de surveillance de lignes d'alimentation (100, 121) comprend :
un module de surveillance de paramètres d'alimentation (71) configuré pour détecter et capter des signaux de tension et des signaux de courant à un emplacement sur une ligne d'alimentation d'une phase, et extraire et déterminer un signal de tension transitoire correspondant et un signal de courant transitoire selon les signaux de tension et les signaux de courant, et notifier un module de captage de signaux synchrone dans un dispositif de surveillance de ligne d'alimentation sur une ligne d'alimentation d'une phase adjacente lors de la surveillance que les étendues de variation dans le signal de tension transitoire et le signal de courant transitoire dépassent des seuils prédéfinis ; et
un module de captage de signaux synchrone (72) configuré pour recevoir une notification d'un module de surveillance de paramètres d'alimentation (71) dans un dispositif de surveillance d'alimentation sur une alimentation d'une phase adjacente pour détecter des signaux de tension et des signaux de courant sur une alimentation d'une phase de manière synchrone avec le module de captage de signaux synchrone (72) dans le dispositif de surveillance d'alimentation sur l'alimentation de la phase adjacente, et rapporter les signaux détectés ;
dans lequel le système comprend en outre une unité de localisation de défauts (122),
dans lequel l'unité de localisation de défauts (122) est configurée pour :
calculer les tensions homopolaires et les courants homopolaires correspondants en fonction des signaux de tension et des signaux de courant qui sont captés de manière synchrone à des emplacements multiples sur les lignes d'alimentation de trois phases,
extraire les signaux en régime permanent et les signaux transitoires des tensions homopolaires et des courants homopolaires à divers emplacements sur les lignes d'alimentation de trois phases, et déterminer une ligne défectueuse en fonction des signaux en régime permanent des tensions homopolaires et des courants homopolaires, et
déterminer un emplacement de défaut spécifique sur la ligne défectueuse selon les signaux transitoires des tensions homopolaires et des courants homopolaires ;
dans lequel l'unité de localisation de défauts (122) comprend :
un module de localisation de ligne défectueuse (1221) configuré pour extraire les signaux en régime permanent des tensions homopolaires et des courants homopolaires à divers emplacements, calculer les valeurs caractéristiques des signaux en régime permanent, les valeurs caractéristiques comprenant : une ou plusieurs valeurs parmi l'amplitude, la valeur moyenne, la valeur différentielle et la valeur intégrale, et la puissance active homopolaire de régime permanent et la puissance réactive homopolaire de régime permanent à chaque emplacement, calculer également les similitudes de forme d'onde entre les signaux de tension homopolaire en régime permanent et de courant homopolaire à divers emplacements, puis éliminer et déterminer la ligne défectueuse en fonction des différences entre les valeurs caractéristiques et les similitudes de forme d'onde des signaux en régime permanent sur les lignes de diverses phases ; et
un module de localisation de point de défaut (1222) configuré pour extraire les signaux transitoires précédemment déterminés de la tension homopolaire et du courant homopolaire à divers emplacements sur la ligne défectueuse, calculer les valeurs caractéristiques des signaux transitoires, les valeurs caractéristiques comprenant : une ou plusieurs valeurs parmi l'amplitude, la valeur moyenne, la valeur différentielle et la valeur intégrale, et la puissance active homopolaire transitoire et la puissance réactive homopolaire transitoire à chaque emplacement, calculer également les similitudes de forme d'onde entre les signaux transitoires de tension homopolaire et de courant homopolaire à divers emplacements, et ensuite éliminer et déterminer un point de défaut de terre sur la ligne défectueuse selon les différences dans les valeurs caractéristiques et les similitudes de forme d'onde des signaux transitoires à divers emplacements sur la ligne défectueuse.

6. Le système de la revendication 5, **caractérisé en ce que** le module de captage de signaux synchrones (72) comprend un module de traitement synchrone (721), et le module de traitement synchrone synchronise le temps par le biais d'une synchronisation par un réseau de communication sans fil à multiplexage par répartition dans le temps en combinaison avec une synchronisation par GPS, permettant ainsi au module de captage de signaux synchrones de capter de manière synchrone les signaux de tension et les signaux de courant sur les lignes d'alimentation de diverses phases sur la base du temps synchronisé.

7. Le système de la revendication 5, **caractérisé en ce qu'**il comprend également :
un module d'indication de défaut (73) configuré pour émettre un signal d'indication en tant qu'indice sur un emplacement du point de défaut après que le point de défaut à la terre a été déterminé, dans lequel spécifiquement, des diodes électroluminescentes à haute luminosité et à grand angle sont utilisées comme lampes indicatrices, et des combinaisons de différents nombres de diodes, de différents intervalles de clignotement et de différentes fréquences de clignotement indiquent différents types de défauts, respectivement.

8. Le système de la revendication 5, 6 ou 7, **caractérisé en ce que** le module de surveillance de paramètres d'alimentation utilise un capteur de tension capacitif pour capter les signaux de tension et utilise un capteur de courant électronique pour capter les signaux de courant ; le capteur de courant électronique comprend un transformateur de courant, et une bobine de Rogowski enroulée ou une bobine de Rogowski sur une carte de circuit imprimé ; et le module de surveillance de paramètres d'alimentation, lorsqu'il surveille que les étendues de la variation des signaux de tension transitoires et des signaux de courant transitoires dépassent des seuils prédéfinis, notifie le module de captage de signaux synchrone dans le dispositif de surveillance de lignes d'alimentation sur l'alimentation de la ligne adjacente avec un signal infrarouge, acoustique, ultrasonique ou de champ magnétique comme signal de déclenchement, et les modes de notification comprennent :
transmettre directement le signal de déclenchement aux modules de captage de signaux synchrones dans les dispositifs de surveillance de lignes d'alimentation sur les lignes d'alimentation des deux autres phases ; ou
transmettre d'abord le signal de déclenchement au module de captage de signaux synchrone dans le dispositif de surveillance de lignes d'alimentation sur l'alimentation d'une phase adjacente, puis transmettre en continu le signal de déclenchement par une unité de surveillance de l'alimentation sur l'alimentation de la phase adjacente à l'alimentation de l'autre phase au module de captage de signaux synchrone dans le dispositif de surveillance de lignes d'alimentation sur l'alimentation de l'autre phase ; ou
transmettre d'abord le signal de déclenchement à un dispositif terminal de communication de sorte que le dispositif terminal de communication transmette le signal de déclenchement aux modules de captage de signaux synchrones dans les dispositifs de surveillance de lignes d'alimentation sur les lignes d'alimentation des deux autres phases.

9. Système de la revendication 5, 6 ou 7, **caractérisé en ce qu'**il comprend également :
un module de communication sans fil (74) configuré pour établir une communication sans fil avec deux dispositifs de surveillance de lignes d'alimentation disposés à des emplacements correspondants sur les alimentations des deux autres phases d'une manière multiplexée par répartition dans le temps, et transmettre des paramètres d'alimentation à partir des deux dispositifs de surveillance de lignes d'alimentation aux emplacements correspondants sur les alimentations des deux autres phases à une station maîtresse du système via un réseau de communication sans fil.

10. Système de la revendication 5, 6 ou 7, **caractérisé en ce qu'**il comprend également :
un module d'acquisition d'énergie (75) comprenant un matériau magnétique capable d'obtenir un circuit magnétique fermé via un mécanisme de verrouillage et configuré pour acquérir de l'énergie électrique à partir du dispositif d'alimentation pour fournir de l'énergie au dispositif de surveillance du dispositif d'alimentation ;
un module de gestion de l'alimentation (76) configuré pour commander le module d'acquisition d'énergie (75) afin d'acquérir de l'énergie électrique à partir de la ligne d'alimentation pour alimenter le dispositif de surveillance de la ligne d'alimentation avec une batterie servant de source d'alimentation de secours ; et
un module de commande de puissance (77) configuré pour commander une puissance constante pour acquérir de l'énergie électrique à partir de l'alimentateur.

11. Le système de la revendication 5, 6 ou 7, **caractérisé en ce qu'**il comprend également un composant de serrage d'alimentateur composé d'un ressort, d'un porte-fil et d'un mécanisme de verrouillage et configuré pour serrer l'alimentateur entre le porte-fil et le ressort, l'alimentateur étant réglable en position au moyen du porte-fil, dans lequel le composant de serrage d'alimentateur est fermement fermé au moyen du mécanisme de verrouillage après avoir serré l'alimentateur.

12. Le système de l'une quelconque des revendications 5 à 11, **caractérisé en ce qu'**il comprend également :
une unité de traitement d'affichage et d'indication de point de défaut (123) configurée pour afficher le point de défaut au sol sur une carte d'un système d'information géographique (GIS) après avoir déterminé le point de défaut au sol, et distribuer un signal de défaut au sol via un réseau de communication sans fil à une unité d'indication de défaut au point de défaut au sol pour afficher le défaut.

13. Le système de l'une quelconque des revendications 5 à 12, **caractérisé en ce qu'**il comprend également :
des dispositifs terminaux de communication (124) configurés pour communiquer avec les dispositifs de surveillance de lignes d'alimentation, transmettre des paramètres surveillés depuis les dispositifs de surveillance de lignes d'alimentation à une unité de localisation de défauts disposée dans une station maîtresse du système, dans lequel chaque dispositif terminal de communication est configuré pour communiquer avec trois dispositifs de surveillance de lignes d'alimentation disposés sur le ou les trois groupes de lignes d'alimentation de trois phases, et une communication sans fil est établie entre le dispositif terminal de communication et chaque dispositif de surveillance de lignes d'alimentation ; et le dispositif terminal de communication communique avec la station maîtresse du système via un réseau de communication sans fil ; ou
un dispositif terminal de communication (124) configuré pour communiquer avec l'un quelconque de trois dispositifs de surveillance de lignes d'alimentation correspondant aux lignes d'alimentation de trois phases et transmettre des paramètres surveillés du dispositif de surveillance de lignes d'alimentation à une unité de localisation de défauts disposée dans une station maître du système, dans lequel le dispositif de surveillance de lignes d'alimentation établit une communication sans fil avec deux dispositifs de surveillance de lignes d'alimentation disposés aux emplacements correspondants sur les lignes d'alimentation des deux autres phases d'une manière multiplexée par répartition dans le temps pour obtenir des paramètres surveillés des deux dispositifs de surveillance de lignes d'alimentation disposés aux emplacements correspondants sur les lignes d'alimentation des deux autres phases ; et le dispositif terminal de communication communique avec la station maîtresse du système via un réseau de communication sans fil ; ou
un dispositif de surveillance de ligne d'alimentation ayant une fonction de terminal de communication, configuré pour établir une communication sans fil avec deux dispositifs de surveillance de lignes d'alimentation disposés aux emplacements correspondants sur les lignes d'alimentation des deux autres phases d'une manière multiplexée par répartition dans le temps pour obtenir des paramètres surveillés à partir des deux dispositifs de surveillance de lignes d'alimentation disposés aux emplacements correspondants sur les lignes d'alimentation des deux autres phases, le dispositif de surveillance de ligne d'alimentation ayant la fonction de terminal de communication communiquant avec la station maîtresse du système via un réseau de communication sans fil et transmettant les paramètres surveillés des phases des trois phases à une unité de localisation de défauts disposée dans une station maîtresse du système.
